(19) Europäisches Patentamt / European Patent Office / Office européen des brevets

(11) **EP 3 379 710 B1**

(12) **FASCICULE DE BREVET EUROPEEN**

(45) Date de publication et mention de la délivrance du brevet:
**27.10.2021  Bulletin 2021/43**

(51) Int Cl.:
***H02M 7/00*** *(2006.01)*      ***H02M 1/32*** *(2007.01)*
***H01L 25/07*** *(2006.01)*

(21) Numéro de dépôt: **17305343.0**

(22) Date de dépôt: **24.03.2017**

(54) **CONVERTISSEUR DE PUISSANCE À DÉCOUPAGE CONFIGURÉ POUR COMMANDER AU MOINS UNE PHASE D'UN RÉCEPTEUR ÉLECTRIQUE POLYPHASÉ À AU MOINS TROIS PHASES**

LEISTUNGSWANDLER ZUR STEUERUNG MINDESTENS EINER PHASE EINES MEHRPHASIGEN ELEKTRISCHEN EMPFÄNGERS MIT MINDESTENS DREI PHASEN

SWITCHING POWER CONVERTER CONFIGURED TO CONTROL AT LEAST ONE PHASE OF A POLYPHASE ELECTRICAL RECEIVER WITH AT LEAST THREE PHASES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**26.09.2018  Bulletin 2018/39**

(73) Titulaire: **Thales**
**92400 Courbevoie (FR)**

(72) Inventeurs:
• **GUILLAUME, Michel**
**1428 Lillois-Witterzee (BE)**
• **GLETON, Laurent**
**6180 Courcelles (BE)**

(74) Mandataire: **Marks & Clerk France**
**Immeuble "Visium"**
**22, avenue Aristide Briand**
**94117 Arcueil Cedex (FR)**

(56) Documents cités:
**DE-A1- 4 435 255       DE-A1-102004 037 078
DE-T5-112013 001 234   DE-U1-202013 104 146
US-A- 5 731 970         US-B1- 6 600 238**

# Description

L'invention porte sur un convertisseur de puissance configuré pour commander au moins une phase d'un récepteur électrique polyphasé à au moins trois phases.

Dans le domaine aérospatial, la tendance générale est de remplacer les actionneurs hydrauliques par des actionneurs électriques dans le but de diminuer les coûts, i.e. de mettre sur le marché des solutions économiquement plus compétitives.

En effet, le concept d'avion électrique devient une réalité avec des surfaces de contrôle qui sont actionnées par des vérins électriques, de même, pour Ariane 6, les actionneurs hydrauliques qui, sur Ariane 5, contrôlent la trajectoire du lanceur en orientant les divergents des boosters à poudre et du moteur de l'étage principal cryogénique seront remplacés par des actionneurs électriques de très haute puissance.

L'accession à de tels niveaux de puissance ne peut être obtenue que par l'élévation de la tension d'alimentation. Par exemple, pour l'étage supérieur d'Ariane 5, la puissance électrique nécessaire pour chacun des deux axes est de l'ordre 5 kW (sous 150 V) tandis que pour les étages à poudre d'Ariane 6, la puissance électrique nécessaire pour chaque axe sera de l'ordre de 70 kW (sous 350V).

D'autre part, de nouvelles applications aérospatiales, telles que le projet Stratobus, un dirigeable autonome évoluant juste au-dessus du trafic aérien, à 20 kilomètres d'altitude, ne peuvent aboutir que dans un contexte de "tout électrique".

La criticité des missions maintenant dévolues aux actionneurs électriques impose de développer des solutions qui, tout en étant tolérantes aux pannes, ne perturbent pas la mission lors de l'occurrence d'une panne.

D'autre part, la concurrence exercée dans les marchés aérospatiaux exige de mettre en œuvre des solutions toujours plus compétitives économiquement.

Au cœur d'un actionneur électrique se trouve une unité de commande électronique (ECPU : Electronic Control and Power Unit); la partie qui pilote le moteur électrique est constituée d'un onduleur de puissance dont les différents modes de panne ne peuvent affecter la mission.

L'électronique de puissance dans les applications à haute fiabilité comme l'aérospatiale, a besoin d'architectures capables de remplir la mission en cas de panne simple.

En d'autres termes, il est nécessaire d'apporter une solution compétitive qui garantit une continuité de service en cas de panne d'un composant électronique, sans reconfigurer et sans dégrader les performances de l'onduleur.

Il est notamment connu deux familles d'onduleurs pour réaliser un onduleur tolérant aux pannes.

Il est connu des onduleurs reconfigurables, dans lesquels des fusibles sont ajoutés en série avec les interrupteurs de puissance, voire des interrupteurs de puissance dans les lignes de phase pour forcer la fonte des fusibles dans certains cas de panne, voire des interrupteurs de puissance pour isoler la phase en panne et la commuter sur un bras d'onduleur de réserve.

Ce type d'architecture suppose qu'une panne simple n'a pas entraîné de propagation de panne sur les autres composants de l'onduleur, voire de court-circuit de la batterie, que toutes les pannes potentielles peuvent être identifiées sans ambiguïté, que les fusibles s'ouvrent dans tous les cas et que les interrupteurs de reconfiguration ne nécessitent pas une implantation plus complexe que la redondance des bras d'onduleur.

En outre, le fonctionnement de ces onduleurs suppose de disposer des moyens de détection de la panne et de conduire l'action appropriée de reconfiguration de l'onduleur qui en inhibe temporairement le fonctionnement.

Ainsi, les applications qui demandent une disponibilité totale de l'onduleur ne pourront utiliser ce type d'architecture car, dès l'occurrence d'une simple panne, le fonctionnement de l'onduleur est dégradé, voire arrêté, et ce manque de disponibilité dure le temps nécessaire à la détection de la panne, à l'identification de l'action corrective à mener et à la conduite de l'action corrective. Dans le cas d'Ariane 6, la mission d'un étage à poudre dure environ deux minutes et vingt secondes durant lesquelles le lanceur quitte le pas de tir pour atteindre une altitude de 70 kilomètres. Une telle mission demande une disponibilité permanente des équipements.

Un moyen connu de gestion des risques de panne consiste à concevoir des onduleurs avec redondance se basant sur la multiplication des composants actifs pour que la panne d'un composant soit compensée, de manière naturelle, par un composant redondant. Pour se prémunir des différents cas de panne, ce type d'architecture conduit à quadrupler les composants :

- pour éviter l'effet de la panne en court-circuit d'un composant, un second composant est ajouté en série ; s'il s'agit d'un composant commandé, la commande est également doublée.
- pour éviter l'effet de la panne en circuit ouvert d'un composant, un second composant est ajouté en parallèle ; s'il s'agit d'un composant commandé, la commande est également doublée.

De même, dans les convertisseurs de puissance à découpage embarqués dans les satellites, les architectures des cellules de commutation doivent pouvoir compenser de manière naturelle la panne d'un composant.

Le défaut majeur de ces solutions est la multiplication des composants qui augmente les coûts et, en augmentant la taille de l'implantation, en augmente également les inductances parasites qui génèrent des surtensions de commutation.

Un moyen connu d'augmentation de la capacité en courant d'un dispositif de puissance est de recourir à la mise en parallèle de sous-ensembles de capacité moindre, de telle manière que leur somme de capacité égale la capacité requise ; cette condition n'est valable que si la répartition du courant entre les différents sous-ensembles est égale.

De l'art antérieur pertinent pour l'invention est DE102004037078 A1, US6600238B1 et US5731970.

La présente invention vise à pallier les inconvénients précédemment cités et, particulièrement le problème de la tolérance aux pannes sans reconfiguration ni dégradation des performances de l'onduleur.

Il est proposé, selon un aspect de l'invention, un convertisseur de puissance à découpage selon la revendication 1.

Ainsi la disposition de mise en série des interrupteurs, d'une part, et la disposition de mise en série des diodes, d'autre part, permet une tolérance à la simple panne en court-circuit des éléments. La disposition de mise en parallèle des $N_i \geq 2$ diodes permet la tolérance à la simple panne en circuit ouvert d'une diode tandis que la disposition de mise en parallèle des deux ensembles d'interrupteurs en parallèle permet la tolérance à la simple panne en circuit ouvert d'un interrupteur.

En outre, les diodes d'un sous-ensemble étant en parallèle avec un excellent couplage thermique entre elles, si une diode s'échauffe, elle échauffe aussi les autres diodes, tendant ainsi à maintenir une bonne répartition du courant entre elles.

En outre, les ensembles d'interrupteurs étant en parallèle avec un couplage thermique minimisé (deux ensembles différents ENS1 et ENS2), si un interrupteur s'échauffe, la ségrégation thermique d'avec les autres interrupteurs de l'autre ensemble lui permet de chauffer librement, sans interférer avec les autres interrupteurs de l'autre ensemble, tendant ainsi à maintenir la bonne répartition du courant.

En outre, lors de son fonctionnement, le demi-bras d'onduleur est parcouru par le courant de phase, en alternance, dans l'ensemble de diodes en série puis, partagé en deux, dans les deux séries d'interrupteurs. La disposition des diodes entre les interrupteurs permet de créer un même chemin moyen du courant, que ce courant circule dans la série de diodes ou, partagé en deux, dans les deux séries d'interrupteurs. Par ce fait, le champ magnétique développé autour du demi-bras d'onduleur par la circulation du courant, varie peu et, l'inductance parasite de commutation est ainsi réduite au minimum. Les surtensions au niveau des diodes et des interrupteurs s'en trouvent ainsi réduites au minimum.

D'autre part, un récepteur électrique polyphasé ayant au minimum trois phases indépendantes possède, par nature, une redondance de phase.

Il est ainsi possible de concevoir un convertisseur de puissance qui exploite cette propriété du récepteur électrique de telle manière qu'une panne en circuit ouvert du convertisseur ou du récepteur soit compensée par la nature redondante du récepteur; cette approche permet de limiter la redondance, pour le convertisseur, à une redondance série qui demande donc moitié moins de composants qu'une redondance série-parallèle classique.

Selon un mode de réalisation, les M sous-ensembles comprennent un même nombre $N_i$ de diodes en parallèle.

Ainsi le comportement d'un demi-bras d'onduleur, en cas de panne en court-circuit d'une diode est identique quel que soit le sous-ensemble de diodes affecté.

Dans un mode de réalisation, le convertisseur de puissance à découpage comprend au moins un capteur de température.

La présence d'au moins un capteur de température permet de contrôler la température de fonctionnement de l'onduleur. Sur base de ce contrôle, une inhibition de l'onduleur en cas de température élevée permet d'éviter des défaillances causées par un dépassement des températures de jonction des semi-conducteurs des interrupteurs et des diodes.

Selon un mode de réalisation, les interrupteurs du premier ensemble sont alignés et/ou les interrupteurs du deuxième ensemble sont alignés et/ou les sous-ensembles de diodes du troisième ensemble sont alignés.

Ainsi, la différence de chemin moyen du courant entre les diodes et les deux séries d'interrupteurs est minimisée, réduisant au minimum l'inductance parasite de commutation et donc, les surtensions au niveau des diodes et des interrupteurs.

Dans un mode de réalisation, un bloc de deux bras comprend une alimentation électrique coplanaire, munie d'une ligne positive et d'une ligne négative, disposée de manière à séparer deux bras du convertisseur, et comprenant une interface de puissance par bras, chaque interface de puissance étant disposée de sorte que les deux demi-bras du bras correspondant, i.e. le demi-bras positif et le demi-bras négatif, sont situés entre l'alimentation électrique coplanaire et l'interface de puissance correspondante.

Ainsi, les raccordements des demi-bras d'onduleur sont effectués avec un minimum d'inductance parasite de manière à réduire les surtensions générées lors de la commutation sur les interrupteurs et les diodes. En effet, le point de sommation des courants commutés dans l'interface de puissance est centré par rapport à la connexion des interrupteurs et des diodes, le reste de l'interface de puissance étant parcouru par le courant de phase. Les lignes d'alimentation coplanaires ayant une très faible inductance parasite, l'alimentation des demi-bras d'onduleur est assurée avec un minimum de surtension lors de la commutation.

Selon un mode de réalisation, deux demi-bras formant un bras d'un bloc de deux bras du convertisseur, comprennent :

un demi-bras positif comprenant un troisième ensemble connecté entre la ligne négative de l'alimentation électrique coplanaire et l'interface de puissance correspondante, et un premier ensemble et un deuxième ensemble connectés entre la ligne positive de l'alimentation électrique coplanaire et l'interface de puissance correspondante, et

un demi-bras négatif comprenant un troisième ensemble connecté entre la ligne positive de l'alimentation électrique coplanaire et l'interface de puissance correspondante, et un premier ensemble et un deuxième ensemble connectés entre la ligne négative de l'alimentation électrique coplanaire et l'interface de puissance correspondante.

Ainsi, lors de la commutation, ces deux demi-bras s'échangent du courant électrique, d'une part, le courant de phase à travers leurs interfaces de puissance et la phase du récepteur et, d'autre part, des courants commutés à travers les lignes coplanaires d'alimentation. Les lignes d'alimentation coplanaires ayant une très faible inductance parasite, l'alimentation des demi-bras d'onduleur est assurée avec un minimum de surtension lors de la commutation.

Par exemple, un demi-bras négatif d'un bras d'un bloc de deux bras du convertisseur est disposé en vis-à-vis d'un demi-bras positif de l'autre bras du bloc de deux bras du convertisseur, par rapport à l'alimentation électrique coplanaire.

La disposition en vis-à-vis des deux demi-bras d'onduleur permet d'optimiser et de réduire la longueur de la circulation des courants commutés dans les lignes coplanaires de manière à réduire à leur strict minimum les inductances parasites et les surtensions de commutation qui leur sont liées.

Dans un mode de réalisation, lorsque le nombre de bras est impair, le convertisseur comprend desdits blocs de deux bras, et un bloc de deux bras muni d'un bras additionnel.

Ainsi, la réalisation de l'onduleur à nombre de bras impairs est conduite de manière à réduire les inductances parasites et les surtensions de commutation liées.

Par exemple, ledit bloc de deux bras est muni d'un bras additionnel comprenant deux demi-bras disposés de part et d'autre de l'alimentation électrique coplanaire prolongée, et une interface de puissance dudit bras additionnel comprenant respectivement, pour chacun des deux demi-bras, une partie disposée de sorte que le demi-bras correspondant est situé entre l'alimentation électrique coplanaire et ladite partie de l'interface de puissance correspondante.

Ainsi, la réalisation de l'onduleur à nombre de bras impair peut être dérivée d'une réalisation à deux bras d'onduleurs; l'ajout du troisième bras revient à dupliquer l'implantation d'une paire de demi-bras en vis-à-vis, permettant ainsi d'exploiter des outillages de fabrication développés pour une réalisation à deux bras d'onduleurs.

Par exemple, ledit bloc de deux bras muni d'un bras additionnel comprend en outre, une portion additionnelle d'alimentation électrique coplanaire disposée à une extrémité et dans une direction différente du reste de l'alimentation électrique coplanaire, et une interface de puissance dudit bras additionnel disposée de sorte que ledit bras additionnel est situé entre ladite portion additionnelle d'alimentation électrique coplanaire et ladite interface de puissance correspondante.

Ainsi, ce mode de réalisation permet de simplifier l'interface de puissance du bras additionnel.

Par exemple, ladite portion additionnelle d'alimentation électrique coplanaire est sensiblement perpendiculaire au reste de l'alimentation électrique coplanaire.

Ainsi, les chemins de circulation des courants de commutation des deux demi-bras du bras additionnel dans les lignes d'alimentation coplanaires sont symétriques, de manière à ce que le fonctionnement du bras d'onduleur soit indépendant du sens du courant de phase.

Selon un mode de réalisation, le convertisseur de puissance à découpage est hybride.

Ainsi, l'utilisation des technologies hybrides permet de maximiser la compacité de l'onduleur ; une solution compacte, par la réduction des longueurs, permet de réduire fortement les inductances parasites et les surtensions qui leur sont liées. D'autre part, l'augmentation de la compacité de la réalisation permet d'en réduire la masse et, en utilisant moins de place dans l'équipement final, permet d'en réduire également la masse.

En outre, l'utilisation des technologies hybrides permet d'optimiser les couplages thermiques entre les composants.

Ainsi, les diodes d'un sous-ensemble étant en parallèle sur la même surface de cuivre garantissant un excellent couplage thermique entre elles, si une diode s'échauffe, elle échauffe aussi les autres diodes, tendant ainsi à maintenir une bonne répartition du courant entre elles.

En outre, les ensembles d'interrupteurs étant en parallèle sur des surfaces de cuivre différentes et éloignées (deux ensembles différents), si un interrupteur s'échauffe, la ségrégation thermique d'avec les autres interrupteurs de l'autre ensemble lui permet de chauffer librement, sans interférer avec les autres interrupteurs de l'autre ensemble, tendant ainsi à maintenir la bonne répartition du courant.

On entend par convertisseur hybride, un module comprenant un ou plusieurs substrats isolés, généralement en céramique, sur lesquels des composants actifs et passifs sont interconnectés dans le but de réaliser une fonction électrique ; les composants actifs pouvant être des puces nues ou des composants encapsulés, les composants passifs pouvant être imprimés sur le substrat ou être des composants à montage de surface. Dans tous les cas, le report des composants se fait en surface. Les substrats sont encapsulés dans un boitier au travers duquel des interconnexions permettent d'accéder à la fonction électrique interne du module.

Selon un mode de réalisation, les interrupteurs comprennent au moins un transistor bipolaire à grille isolée et/ou au moins un transistor à effet de champ à grille isolée.

Ainsi, la commande de l'interrupteur est simplifiée; lorsque la grille est polarisée, l'interrupteur est actif, lorsque la grille est dépolarisée, l'interrupteur est inhibé. Le circuit de commande est alors assez simple puisqu'il doit injecter des charges électriques dans la grille pour activer l'interrupteur et retirer ces charges pour l'inhiber. D'autre part, l'inhibition de l'interrupteur n'étant fonction que de la commande de la grille, au contraire du thyristor, par exemple, l'interrupteur peut être utilisé, de manière indifférente, dans des topologies à commutation naturelles, c'est-à-dire celles où l'interrupteur est ouvert lorsque le courant qui le traverse s'annule, et dans des topologies à commutation forcée, c'est-à-dire celles où l'interrupteur est ouvert alors que le courant le traverse.

Par exemple, ledit convertisseur étant un onduleur ou un hacheur.

Selon un autre aspect de l'invention, il est également proposé un système de commande d'au moins un vérin électrique d'un lanceur spatial comprenant au moins un convertisseur de puissance à découpage selon l'une des revendications précédentes, le récepteur électrique étant un moteur électrique et le convertisseur de puissance étant un onduleur.

Ainsi, le système de commande permet une modulation fine de la puissance appliquée au vérin. D'autre part, l'onduleur étant réversible, il permet de renvoyer vers la batterie l'énergie qui est extraite du vérin au lieu de la perdre, comme dans un système hydraulique à huile perdue utilisé actuellement sur les étages inférieurs d'Ariane 5.

Selon un autre aspect de l'invention, il est également proposé un lanceur spatial muni d'un système tel que précédemment décrit.

Ainsi, un tel système permet de libérer l'opérateur du lanceur des contraintes d'exploitation générées par les mesures de sécurité à mettre en œuvre lors de l'utilisation de systèmes hydrauliques à huile perdue dans lesquels la source d'énergie est constituée par de grands réservoirs d'huile mis sous haute pression par de l'air comprimé à 200 bars. De plus, un tel système peut être alimenté à partir de batteries thermiques qui, ayant la particularité d'être inertes tant qu'elles ne sont pas activées, permettent à l'opérateur du lanceur de se libérer également des contraintes d'exploitation liées à l'utilisation d'accumulateurs électriques.

Selon un autre aspect de l'invention, il est également proposé un système de commande d'au moins un dispositif d'orientation d'antennes ou de panneaux solaires d'un satellite comprenant au moins un convertisseur de puissance à découpage tel que précédemment décrit, le récepteur électrique étant un moteur électrique et le convertisseur de puissance étant un onduleur.

Ainsi, les niveaux de surtension aux bornes du convertisseur peuvent être limités par rapport à celles induites par les autres systèmes, permettant un plus juste dimensionnement du système.

Selon un autre aspect de l'invention, il est également proposé un satellite muni d'un système de commande tel que précédemment décrit.

Selon un autre aspect de l'invention, il est également proposé un système d'alimentation d'un satellite comprenant au moins un convertisseur de puissance à découpage tel que décrit précédemment, le récepteur électrique étant un transformateur polyphasé et le convertisseur de puissance étant un onduleur ou hacheur.

Ainsi, les niveaux de surtension aux bornes du convertisseur peuvent être limités par rapport à ceux induits par les autres systèmes, permettant un plus juste dimensionnement du système.

Selon un autre aspect de l'invention, il est également proposé un satellite muni d'un système d'alimentation tel que précédemment décrit.

Plus généralement, la présente invention peut s'appliquer à toute application où la maîtrise des surtensions est requise, même une station orbitale.

L'invention sera mieux comprise à l'étude de quelques modes de réalisation décrits à titre d'exemples nullement limitatifs et illustrés par les dessins annexés sur lesquels :

- les figures 1a et 1b illustrent schématiquement les cinq moments d'une période de commutation de la tension électrique dans le fonctionnement d'un pont en H d'onduleur pour un courant électrique de phase positif d'un récepteur électrique;

- les figures 2a et 2b illustrent schématiquement les cinq moments d'une période de commutation de la tension électrique dans le fonctionnement d'un pont en H d'onduleur pour un courant électrique de phase négatif d'un récepteur électrique;

- les figures 3a et 3b illustrent schématiquement les sept moments d'une période de commutation de la tension électrique dans le fonctionnement d'un onduleur pour un récepteur électrique à trois phase et point neutre;

- les figures 4a et 4b illustrent respectivement un demi-bras détaillé et synthétique d'un convertisseur de puissance à découpage, lorsque $P=2$, $M=2$, $N_1=2$, et $N_2=2$, selon un aspect de l'invention;

- Les figures 4c, 4d, 4e, 4f, 4g, 4h, 4i et 4j illustrent alternativement de manière détaillée et schématique un demi-bras d'un convertisseur de puissance à découpage, lorsque $P=2$, $M=2$, $N_1=2$, et $N_2=2$, selon divers aspects de l'invention;

- les figures 5a, 5b, représentent un bras d'un convertisseur de puissance à découpage, lorsque $P=2$, $M=2$, $N_1=2$, et $N_2=2$, et la figure 5c représente un bloc de deux bras, pouvant par exemple être utilisé comme pont en H ou comme double bras d'un convertisseur de puissance à découpage, lorsque $P=2$, $M=2$, $N_1=2$, et $N_2=2$, selon des aspects de l'invention;

- les figures 6a et 6b représentent des exemples de réalisation d'un bloc de deux bras muni d'un bras additionnel pour un nombre total de bras impair, selon divers aspects de l'invention;
- les figures 7a et 7b illustrent les circulations des courants électriques dans un bloc de deux bras utilisé comme pont en H pour une phase de récepteur électrique respectivement pour un courant électrique positif et un courant électrique négatif; et
- la figure 8a illustre le cas d'un nombre de phases impair, en l'occurrence trois phases et un neutre du récepteur électrique; et
- les figures 8b et 8c illustrent les circulations des courants électriques dans un bloc des figures 6a et 6b avec un récepteur électrique à trois phases et neutre.

Sur les différentes figures, les éléments ayant des références identiques sont identiques. Dans les exemples qui suivent, N vaut 2, mais bien entendu les exemples décrits s'appliquent en variante à toute valeur de N.

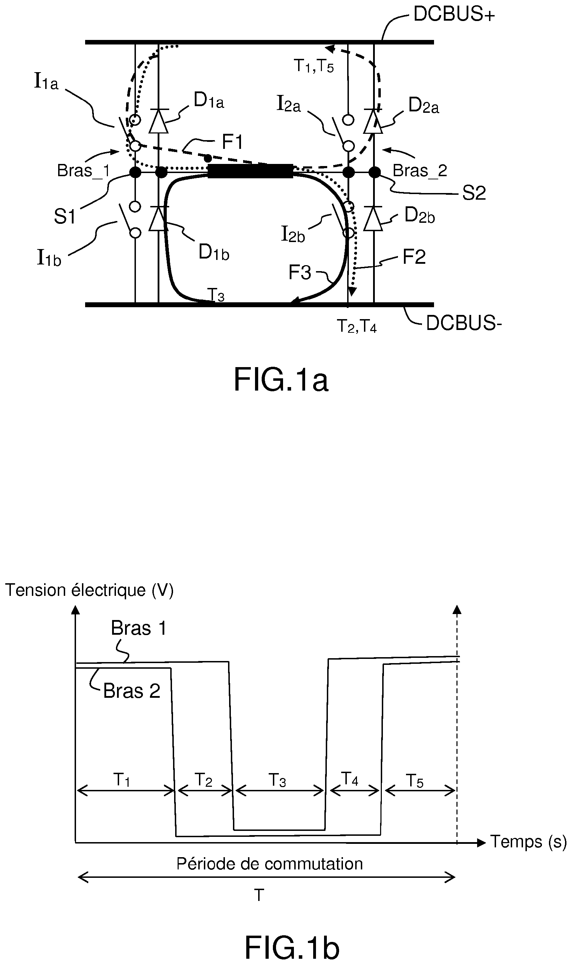

Les figures 1a et 1b représentent les cinq moments d'une période de commutation de la tension électrique dans le fonctionnement d'un pont en H d'onduleur pour un courant électrique de phase positif d'un récepteur électrique. On appelle courant électrique de phase positif un courant entrant par la borne Active de la phase, repérée par un gros point sur les figures, et sortant par la borne Retour de la phase. La dénomination Active et Retour des bornes de la phase est déterminée par le fabricant du récepteur électrique en fonction du sens du champ magnétique développé par la phase au sein du récepteur électrique.

La figure 1a représente un pont en H d'onduleur commandant une phase Phase d'un récepteur électrique tel un moteur électrique comprenant une alimentation électrique positive DCBUS+ et une alimentation électrique négative DCBUS-, et les deux bras du pont en H, Bras_1 et Bras_2.

Le premier bras Bras_1 du pont en H comprend deux interrupteurs $I_{1a}$, $I_{1b}$ et deux diodes $D_{1a}$, $D_{1b}$, et le deuxième bras Bras_2 du pont en H comprend deux interrupteurs $I_{2a}$, $I_{2b}$ et deux diodes $D_{2a}$, $D_{2b}$.

La figure 1b représente cinq moments successifs $T_1$, $T_2$, $T_3$, $T_4$ et $T_5$ d'une période de commutation d'un courant électrique de phase positif dans le pont en H, pour les tensions électriques mesurées respectivement aux points S1 et S2 par rapport à la ligne d'alimentation DCBUS- des deux bras Bras_1, Bras_2.

Les moments $T_1$ et $T_5$ correspondent aux cas des interrupteurs $I_{1a}$ du premier bras Bras_1 et $I_{2a}$ du deuxième bras Bras_2 fermés ou actifs, dans lesquels le courant électrique de phase est rebouclé à travers la ligne positive d'alimentation DCBUS+; ces délais correspondent à une "roue libre" positive, comme illustré par la flèche F1, en trait de tirets.

On entend par "roue libre" ce qui suit. Si on souhaite faire passer un certain niveau de courant électrique dans une inductance ou self à partir d'une source de tension électrique, le meilleur moyen est de prendre un interrupteur et de délivrer à l'inductance des impulsions de tension régulières dont la valeur, en volts, et la durée, en secondes, font augmenter le courant électrique dans

$$\frac{di}{dt} = \frac{e}{L}$$

l'inductance suivant la loi         dans laquelle i représente l'intensité du courant électrique en ampères, L représente l'inductance en henry, et e représente la force électromotrice, en volts. L'ennui, avec une inductance, est que le courant électrique ne peut être interrompu brusquement; en effet, suivant la même loi, annuler rapidement un courant électrique existant demande de développer aux bornes de l'inductance une tension infinie. D'autre part, une inductance parcourue par un courant électrique i contient une énergie stockée $W = 1/2\, Li^2$ ; tant que le courant électrique circule, cette énergie reste stockée dans l'inductance, y compris si on la court-circuite; par contre, si un circuit externe la force à développer de la tension électrique, son énergie décroît. Aussi, pour alimenter une inductance, est-il nécessaire d'alterner les périodes d'alimentation de l'inductance avec des périodes dites de "roue libre", pendant lesquelles le courant électrique qui circulait précédemment dans l'inductance est maintenu par un circuit extérieur, sous une tension la plus faible possible, de façon à conserver l'énergie dans l'inductance.

La "roue libre", un peu comme dans le cas d'un vélo, est une période pendant laquelle le courant électrique circule sans entraîner d'augmentation ou de diminution notable de l'énergie stockée dans l'inductance.

Les moments $T_2$ et $T_4$ correspondent aux cas des interrupteurs $I_{1a}$ du premier bras Bras_1 et $I_{2b}$ du deuxième bras Bras_2 fermés ou actifs, dans lesquels le courant électrique de phase est dérivé de la ligne d'alimentation positive DCBUS+ vers la ligne d'alimentation négative DCBUS-; ces délais correspondent au transfert d'énergie, comme illustré par la flèche F2 en trait de pointillés.

Le moment $T_3$ correspond aux cas des interrupteurs $I_{1b}$ du premier bras Bras_1 et $I_{2b}$ du deuxième bras Bras_2 fermés ou actifs, dans lesquels le courant de phase est rebouclé à travers la ligne négative d'alimentation DCBUS-; ce délai correspond à une "roue libre" négative, comme illustré par la flèche F3 en trait plein ou continu.

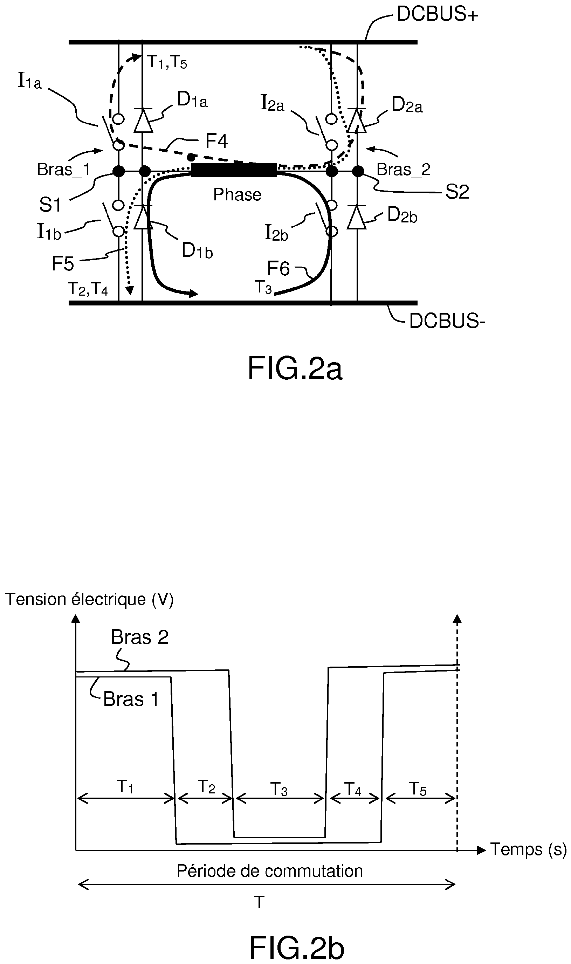

Les figures 2a et 2b représentent les cinq moments d'une période de commutation de la tension électrique dans le fonctionnement d'un pont en H d'onduleur pour un courant électrique de phase négatif d'un récepteur électrique. On appelle courant électrique de phase négatif un courant entrant par la borne Retour de la phase et sortant par la borne Active de la phase, repérée par un point sur le schéma. La dénomination Active et Retour des bornes de la phase est déterminée par le fabricant du récepteur électrique en fonction du sens du champ magnétique développé par la phase au sein du récepteur électrique.

La figure 2a représente un pont en H d'onduleur commandant une phase Phase d'un récepteur électrique tel un moteur électrique comprenant une alimentation électrique positive DCBUS+ et une alimentation électrique négative DCBUS-, et les deux bras du pont en H, Bras1 et Bras2.

Le premier bras Bras_1 du pont en H comprend deux interrupteurs $I_{1a}$, $I_{1b}$ et deux diodes $D_{1a}$, $D_{1b}$, et le deuxième bras Bras_2 du pont en H comprend deux interrupteurs $I_{2a}$, $I_{2b}$ et deux diodes $D_{2a}$, $D_{2b}$.

La figure 2b représente cinq moments successifs $T_1$, $T_2$, $T_3$, $T_4$ et $T_5$ d'une période de commutation d'un courant électrique de phase négatif dans le pont en H, pour les tensions électriques mesurées respectivement aux points S1 et S2 par rapport à la ligne d'alimentation DCBUS- des deux bras Bras_1, Bras_2.

Les moments $T_1$ et $T_5$ correspondent aux cas des interrupteurs $I_{1a}$ du premier bras Bras_1 et $I_{2a}$ du deuxième bras Bras_2 fermés ou actifs, dans lesquels le courant électrique de phase est rebouclé à travers la ligne positive d'alimentation DCBUS+; ces délais correspondent à une "roue libre" positive, comme illustré par la flèche F4 en trait de tirets.

Les moments $T_2$ et $T_4$ correspondent aux cas des interrupteurs $I_{1b}$ du premier bras Bras_1 et $I_{2a}$ du deuxième bras Bras_2 fermés ou actifs, dans lesquels le courant électrique de phase est dérivé de la ligne d'alimentation positive DCBUS+ vers la ligne d'alimentation négative DCBUS-; ces délais correspondent au transfert d'énergie, comme illustré par la flèche F5 en trait de pointillés.

Le moment $T_3$ correspond aux cas des interrupteurs $I_{1b}$ du premier bras Bras_1 et $I_{2b}$ du deuxième bras Bras_2 fermés ou actifs, dans lesquels le courant électrique de phase est rebouclé à travers la ligne négative d'alimentation DCBUS-; ce délai correspond à une "roue libre" négative, comme illustré par la flèche F6 en trait plein ou continu.

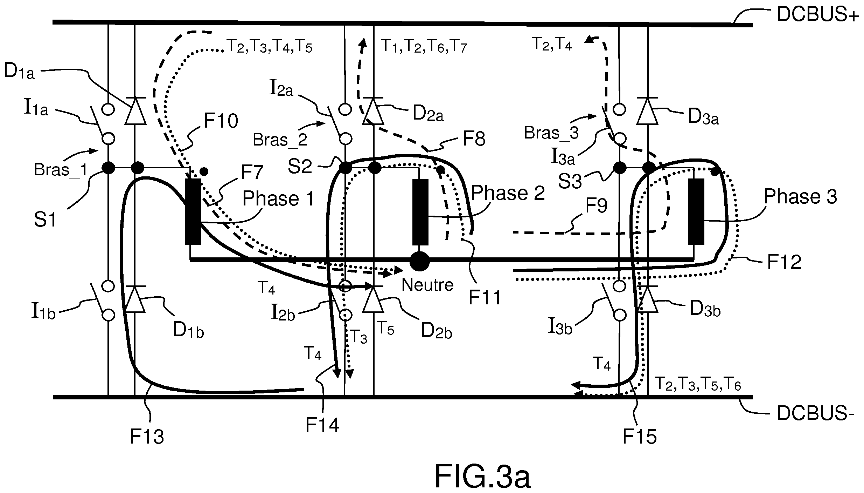

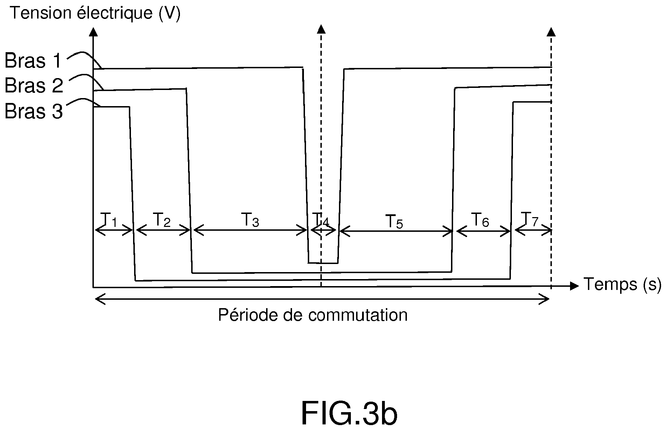

Les figures 3a et 3b représentent les sept moments d'une période de commutation de la tension électrique dans le fonctionnement d'un onduleur à trois bras pour un récepteur électrique tel un moteur électrique à trois phases Phase1, Phase2, Phase3, et point neutre Neutre.

La figure 3a représente un onduleur à trois bras Bras_1, Bras_2 et Bras_3 comprenant une alimentation électrique positive DCBUS+ et une alimentation électrique négative DCBUS-.

Le premier bras Bras_1 de l'onduleur comprend deux interrupteurs $I_{1a}$, $I_{1b}$ et deux diodes $D_{1a}$, $D_{1b}$, le deuxième bras Bras_2 du pont en H comprend deux interrupteurs $I_{2a}$, $I_{2b}$ et deux diodes $D_{2a}$, $D_{2b}$, et le troisième bras Bras_3 comprend deux interrupteurs $I_{3a}$, $I_{3b}$ et deux diodes $D_{3a}$, $D_{3b}$.

La figure 3b représente sept moments successifs $T_1$, $T_2$, $T_3$, $T_4$, $T_5$, $T_6$, et $T_7$ d'une période de commutation d'un courant électrique de phase positif dans l'onduleur, pour les tensions électriques mesurées respectivement aux points S1, S2 et S3 par rapport à la ligne d'alimentation DCBUS- des trois bras Bras_1, Bras_2, et Bras_3.

Le fonctionnement d'un onduleur à M phases se décompose en 2M+1 périodes, en l'espèce dans le cas décrit le fonctionnement d'un onduleur à trois phases se décomposant en sept moments ou sept délais successifs $T_1$, $T_2$, $T_3$, $T_4$, $T_5$, $T_6$, et $T_7$.

La figure 3b ci-dessous montre le fonctionnement d'un onduleur triphasé Phase1, Phase2, Phase3 à trois bras Bras_1, Bras_2, et Bras_3 qui comporte sept périodes de fonctionnement $T_1$, $T_2$, $T_3$, $T_4$, $T_5$, $T_6$, et $T_7$ (pour les besoins de l'explication, son fonctionnement est figé à +15°, ce qui entraine une répartition des courants électriques suivant les proportions respectives de +97%, -70% et -27% dans son repère triphasé cosinusoïdal).

Les moments $T_1$ et $T_7$ correspondent aux cas des interrupteurs $I_{1a}$ du premier bras Bras_1, $I_{2a}$ du deuxième bras Bras_2 et $I_{3a}$ du troisième bras Bras_3 fermés ou actifs, dans lesquels les courants électriques de phase sont rebouclés à travers la ligne positive d'alimentation DCBUS+, ce temps correspond à une "roue libre" positive comme illustré par les flèches F7, F8, et F9.

Les moments $T_2$ et $T_6$ correspondent aux cas des interrupteurs $I_{1a}$ du premier bras Bras_1, $I_{2a}$ du deuxième bras Bras_2, et $I_{3b}$ du troisième bras Bras_3 fermés ou actifs, dans lesquels le courant électriques de la phase Phase3 est dérivé de l'alimentation DCBUS+, c'est une durée pendant laquelle le transfert d'énergie est opéré tandis que le courant électrique de la phase Phase2 est encore en "roue libre" positive; le courant électrique de la phase Phase1 est la somme des deux autres courants comme illustré par les flèches F10, F8, et F12.

Les moments $T_3$ et $T_5$ correspondent aux cas des interrupteurs $I_{1a}$ du premier bras Bras_1, $I_{2b}$ du deuxième bras Bras_2, et $I_{3b}$ du troisième bras Bras_3 fermés ou actifs, dans lesquels les courants électriques des phases Phase2 et Phase3 sont dérivé de l'alimentation DCBUS+, c'est une durée pendant laquelle le transfert d'énergie est opéré; le courant électrique de la phase Phase1 est la somme des deux autres courants électriques, comme illustré par les flèches F10, F11, et F12.

Le moment $T_4$ correspond au cas des interrupteurs $I_{1b}$ du premier bras Bras_1, $I_{2b}$ du deuxième bras Bras_2, et $I_{3b}$ du troisième bras Bras_3 fermés ou actifs, dans lequel les courants électriques de phase des phases Phase1, Phase2, Phase3 sont rebouclés à travers la ligne négative d'alimentation DCBUS-, ce délai correspond à une "roue libre" négative, comme illustré par les flèches F13, F14, et F15.

Comme décrit ci-dessus, le courant de phase passe, tour à tour, par le "haut" et le "bas" des bras Bras_1 et Bras_2 avec des temps de montée et de descente de l'ordre de 1 A/ns. Aussi, les inductances parasites réparties dans le circuit génèrent des surtensions à raison de 1 Volt/nH. Ces inductances parasites sont réparties dans les bras d'onduleur mais également dans les liaisons « DCBUS ».

Sachant qu'un fil simple développe 10nH/cm, sans précautions, un demi bras d'onduleur de 15cm est le siège de surtensions de l'ordre de 150 V soit, plus de la moitié de la tension aéronautique (270 V dc) voire l'entièreté de la tension d'alimentation pour certaines applications lanceur (Ariane 5ME et Ariane 6, étage supérieur : 150 V).

Ces surtensions nécessitent de surdimensionner les composants et les technologies de réalisation de l'équipement pour résister au surcroît du taux de charge dans les composants qu'elles génèrent.

Par exemple, un onduleur alimenté par des batteries de 320 V peut être réalisé avec des puces de 650V, d'une surface de 100 mm$^2$ pour les IGBT et de 38 mm$^2$ pour les diodes. Lorsque les surtensions nécessitent d'utiliser des composants avec une tenue en tension supérieure, il faut utiliser des puces de 1200 V; la tenue à une tension supérieure implique d'avoir des puces plus épaisses. Or, les diodes, tout comme les IGBT, conduisent le courant dans l'épaisseur de la puce si bien que, pour conserver les mêmes pertes en conduction, la surface de l'IGBT passe à 193mm$^2$ et celle de la diode à 81mm$^2$.

Actuellement, le marché ne propose pas de modules hybrides disponibles sur catalogue, de grade Haute Fiabilité, voire de grade industriel, qui intègrent la tolérance aux pannes par redondance.

Il faut ainsi construire une solution discrète mais qui, intrinsèquement, ne serait ni extrêmement compacte et donc sujette aux surtensions, ni optimisée thermiquement et donc surdimensionnée soit développer un circuit hybride spécifique qui permettra d'exploiter tous les avantages de cette invention.

La présente invention met en œuvre le minimum de redondance des composants de puissance nécessaire pour résoudre le problème de la tolérance aux pannes sans reconfiguration.

Par l'optimisation de la redondance, la présente invention permet de définir une implantation compacte qui, en réduisant drastiquement les inductances parasites, améliore les performances de l'onduleur tout en réduisant les surtensions de commutation.

L'architecture proposée s'applique aux moteurs à au moins trois phases, commandés par des ponts en H ; elle s'appuie sur les trois constats suivants:

- les moteurs polyphasés à n-phases, commandés par la technique du contrôle vectoriel (transformées de Park, Concordia), ont la faculté de pouvoir fonctionner naturellement sur n-1 phases lorsque la phase en panne est perdue en circuit ouvert;
- aucun mode de panne ne peut court-circuiter la batterie sans risquer une propagation de panne; et

- la perte d'une diode de roue libre conduit l'inductance de la phase du moteur correspondante à développer une tension risquant de propager la panne.

Sur cette base, la tolérance à la simple panne de la solution proposée s'articule sur deux moyens :

- Les interrupteurs de puissance sont redondés série. Ainsi, une panne d'un interrupteur en circuit ouvert correspond à une phase ouverte, ce qui est acceptable, et une panne en court-circuit est contournée par la redondance série, ce qui est demandé. En outre, une panne en court-circuit d'un interrupteur ne conduit pas à un court-circuit de la batterie, ni de la phase du moteur, ce qui est demandé.

- Les diodes de puissance sont redondées série et parallèle.
  Ainsi, une panne d'une diode en circuit ouvert est compensée par la diode parallèle, ce qui est demandé, et une panne en court-circuit est contournée par la redondance série, ce qui est demandé. En outre, la panne en court-circuit d'une diode ne conduit pas à un court-circuit de la batterie, ni de la phase moteur, ce qui est demandé.

Toutes les idées développées dans la présente invention sont applicables aux onduleurs réalisés avec des composants discrets, cependant, l'implantation de la présente invention dans un hybride de puissance permet de bénéficier au maximum des techniques de réduction des inductances parasites grâce à l'effet multiplicateur de l'augmentation de compacité de la solution par l'hybridation.

D'autre part, le regroupement ou la séparation des composants de puissance suivant leur coefficient de température, négatif ou positif, permet d'optimiser le partage du courant entre les composants.

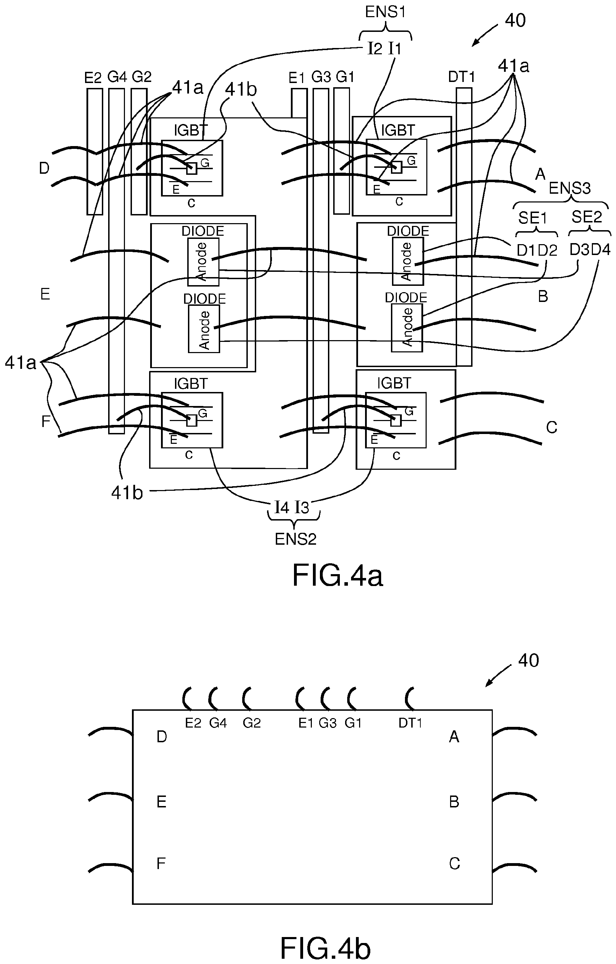

Les figures 4a et 4b illustrent respectivement un demi-bras détaillé 4a et synthétique 4b d'un convertisseur de puissance à découpage, lorsque P=2, M=2, $N_1$=2, et $N_2$=2, comme un onduleur, un hacheur, ou un gradateur, configuré pour commander au moins une phase d'un récepteur électrique polyphasé à au moins trois phases, tel un moteur électrique ou un transformateur, comprenant au moins deux bras de convertisseur. Ce mode de réalisation n'est nullement limitatif.

Les interrupteurs peuvent comprendre au moins un transistor bipolaire à grille isolée ou IGBT pour acronyme de "Insulated Gate Bipolar Transistor" en langue anglaise et/ou au moins un transistor à effet de champ à grille isolée ou MOSFET pour acronyme de "Metal Oxide Semiconductor Field Effect Transistor" en langue anglaise. Dans les exemples décrits, les interrupteurs sont des transistors bipolaires à grille isolée ou IGBT, de manière non limitative.

La figure 4a représente de manière détaillée un demi-bras 40 d'un convertisseur de puissance à décou-

Un tel demi-bras 40 d'un bras de convertisseur de puissance à découpage comprend un premier ensemble ENS1 de P≥2 interrupteurs en série, en l'espèce deux interrupteurs I1, I2, disposés en série, un deuxième ensemble ENS2 de P≥2 interrupteurs en série, en l'espèce deux interrupteurs I3, I4, disposés en série, et un troisième ensemble ENS3 de diodes, disposé entre le premier ensemble ENS1 et le deuxième ensemble ENS2, comprenant M≥2 sous-ensembles SE1, SE2, ...SEM, indicés $i \in [\![1;M]\!]$, en l'espèce deux sous-ensembles SE1, SE2 en série, comprenant respectivement $N_i$≥2 diodes en parallèle, en l'espèce respectivement deux diodes en parallèles, D1 et D2, ainsi que D3 et D4.

Les différentes connexions sont représentées par des fils de connexion 41a, et représentées par des fils de connexion bas niveau 41b.

Les connexions d'émetteur E1, E2 des interrupteurs I1, I2, I3, I4 sont utilisées comme retour de la commande des interrupteurs I1, I2, I3, I4.

Les connexions G1, G2, G3, G4 de grille des interrupteurs transistors I1, I2, I3, I4 sont utilisées pour la commande des interrupteurs I1, I2, I3, I4.

Le point milieu DT1 de la mise en série des sous-ensembles SE1, SE2 de diodes peut servir à de l'autotest.

Les connexions vers l'extérieur de ce demi-bras 40 sont référencées A, B, C, D, E et F, afin de pouvoir les repérer dans les représentations synthétiques qui suivent.

La figure 4b est une version synthétique de la figure 4a.

Une des caractéristiques principale des diodes est leur coefficient de température négatif. Cela signifie que la tension directe relevée aux bornes d'une diode parcourue par un courant électrique donné diminue au fur et à mesure que la température de la diode augmente.

Dans le cas d'une mise en parallèle de diodes, le partage du courant électrique entre elles dépend de leur caractéristique courant/tension individuelle. Si une différence de température apparaît entre les diodes, les diodes plus chaudes sont parcourues par un courant plus important qui, en retour, échauffe plus encore lesdites diodes avec la possibilité d'un emballement thermique.

Aussi, l'implantation proposée prescrit de regrouper les diodes en parallèle sur la même surface de cuivre de façon à ce que, lorsqu'une diode s'échauffe, elle échauffe aussi les autres diodes, tendant ainsi à maintenir la bonne répartition du courant.

Au contraire des diodes, une des caractéristiques principale des IGBT ou interrupteurs est leur coefficient de température positif. Cela signifie que la tension électrique entre le collecteur et l'émetteur relevée aux bornes d'un IGBT saturé, parcouru par un courant de collecteur donné, augmente au fur et à mesure que la température de l'IGBT augmente.

Tout comme pour les diodes, dans le cas d'une mise en parallèle d'IGBT, le partage du courant entre eux dépend de leur caractéristique courant/tension individuelle. Par contre, si une différence de température apparaît entre les IGBT, les IGBT plus chauds sont parcourus par un courant plus faible qui, en retour, échauffe moins lesdits IGBT ce qui permet, si chaque IGBT peut voir sa température évoluer librement, de stabiliser le partage du courant entre les IGBT.

Aussi, l'implantation proposée prescrit de dissocier les IGBT en parallèle sur des surfaces de cuivre différentes et éloignées, de façon à ce que, dans le cas où un IGBT s'échauffe, la ségrégation thermique d'avec les autres IGBT lui permet de chauffer librement, sans interférer avec les autres IGBT, tendant ainsi à maintenir la bonne répartition du courant.

Il convient de noter ici que le substrat utilisé est composé d'une couche de cuivre, sur laquelle sont brasées les puces, reposant sur une céramique de type alumine qui est reportée sur une seconde couche de cuivre en contact direct ou indirect avec un dissipateur. Par la présence de la céramique qui a une résistance thermique plus élevée que celle de la face supérieure de cuivre dans l'empilement de l'hybride de puissance, la puissance thermique se diffuse préférentiellement dans toute la face supérieure de cuivre (horizontalement), ce qui provoque l'échauffement des autres éléments communs à cette couche de cuivre et qui est, précisément, l'effet recherché pour les diodes.

Par contre, comme les interfaces en-dessous de la céramique sont de bons conducteurs thermiques, la chaleur se transmet sensiblement de manière égale en horizontal comme en vertical dans la céramique si bien qu'à partir d'une distance égale à l'épaisseur de la céramique, il n'y aura pas de "diaphonie thermique"; ce qui est l'effet recherché pour les IGBT.

Comme indiqué précédemment, le courant de phase est commuté entre diodes et interrupteurs de puissance aussi, la vitesse de variation du courant étant rapide, la moindre inductance parasite génère des surtensions de commutation notables.

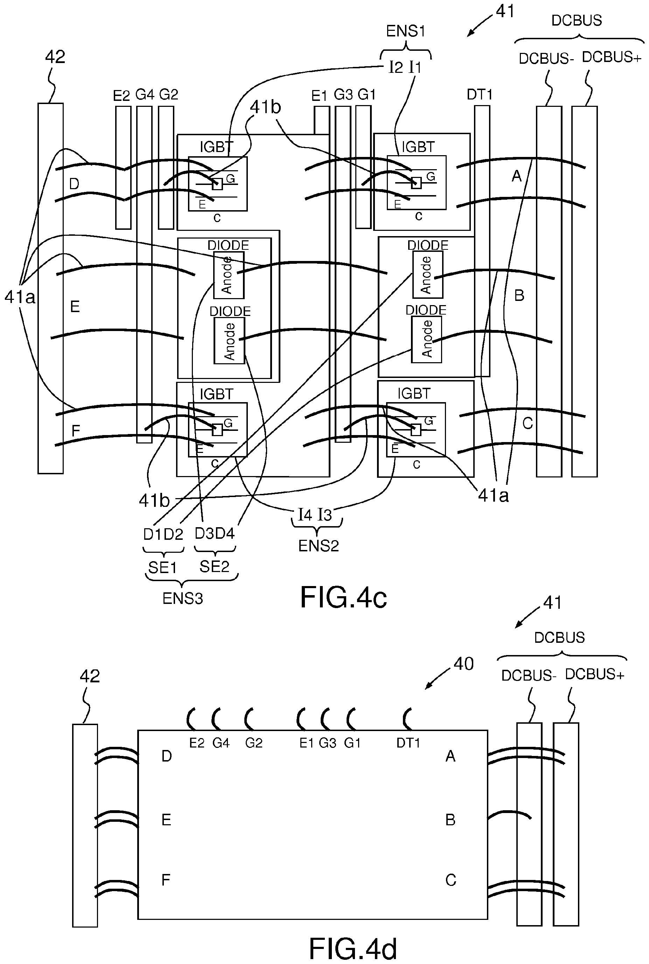

Dans le cas d'un courant positif, le courant de phase est commuté respectivement entre les groupes ENS1 et ENS2, d'une part, et le groupe ENS3, pour la sortie 42 à la figure 4C

La présente invention prescrit :

- de rassembler le groupe de diodes mises en parallèle sur une seule surface; et
- de placer le groupe de diodes au milieu du groupe d'interrupteurs qui est scindé en deux branches dans lesquelles le courant se répartit. Le reste du schéma étant implanté suivant le même principe.

Le courant de phase circule soit dans la branche centrale constituée du groupe de diodes ENS3, soit, se répartit entre les deux branches d'IGBT ENS1, ENS2.

Le couplage inductif mutuel fort de la branche ENS3 à diodes sur celles ENS1, ENS2 à IGBT (et inversement), rend l'inductance de commutation très faible, ce qui est le but recherché.

Les principes exposés précédemment permettent de concevoir un circuit permettant une optimisation poussée de la conception d'un hybride de puissance.

En cours de commutation, lors des phases dites de roue libre, les courants s'échangent entre les bras d'onduleur du pont en H à travers les lignes d'alimentation.

Suivant l'inductance parasite de ces lignes, des surtensions sont générées aux bornes des composants actifs.

La présente invention propose de placer les bras d'onduleur dos à dos, de manière à ce que les échanges de courant entre les deux bras d'onduleur soient les plus directs possible, donc les moins inductifs possibles

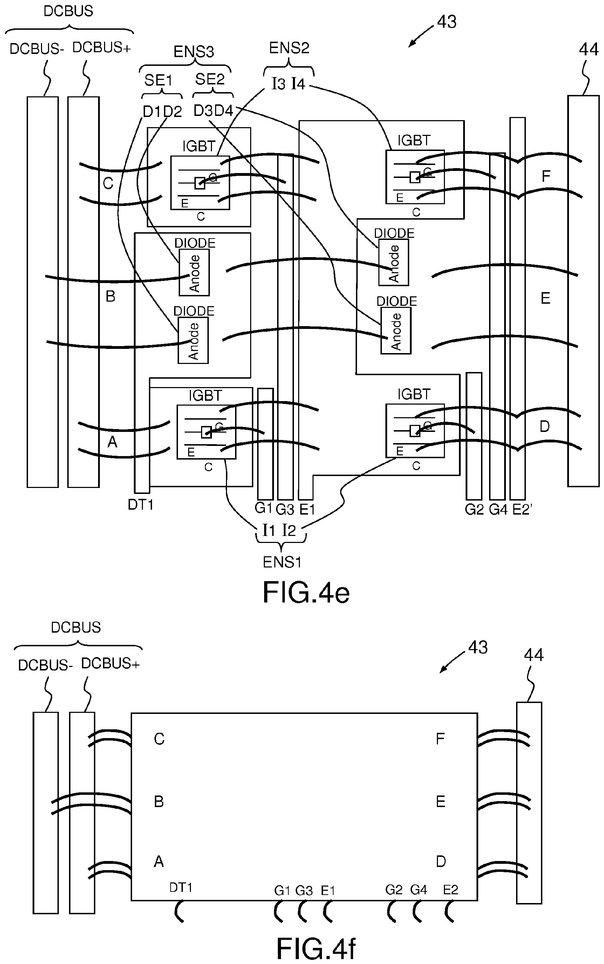

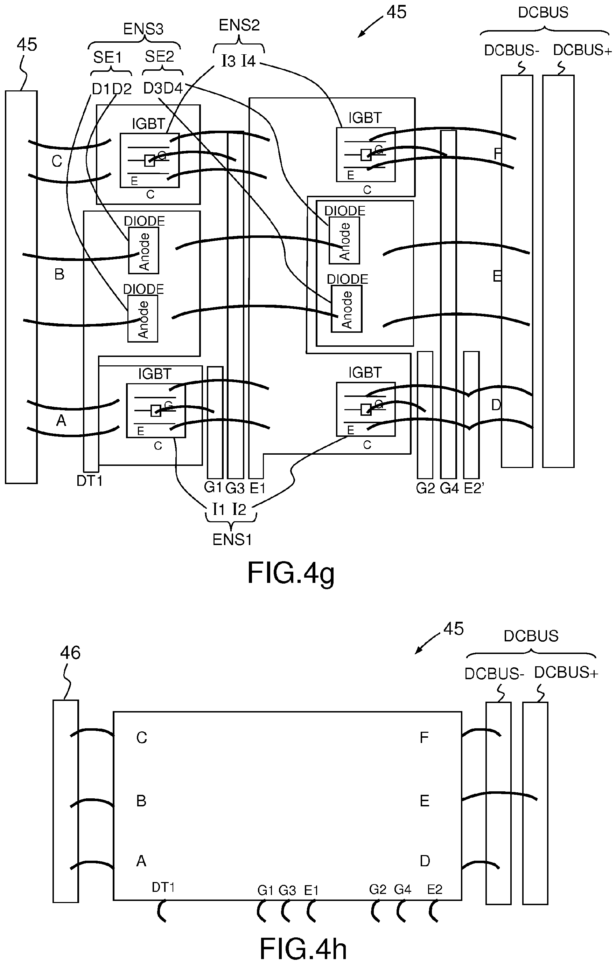

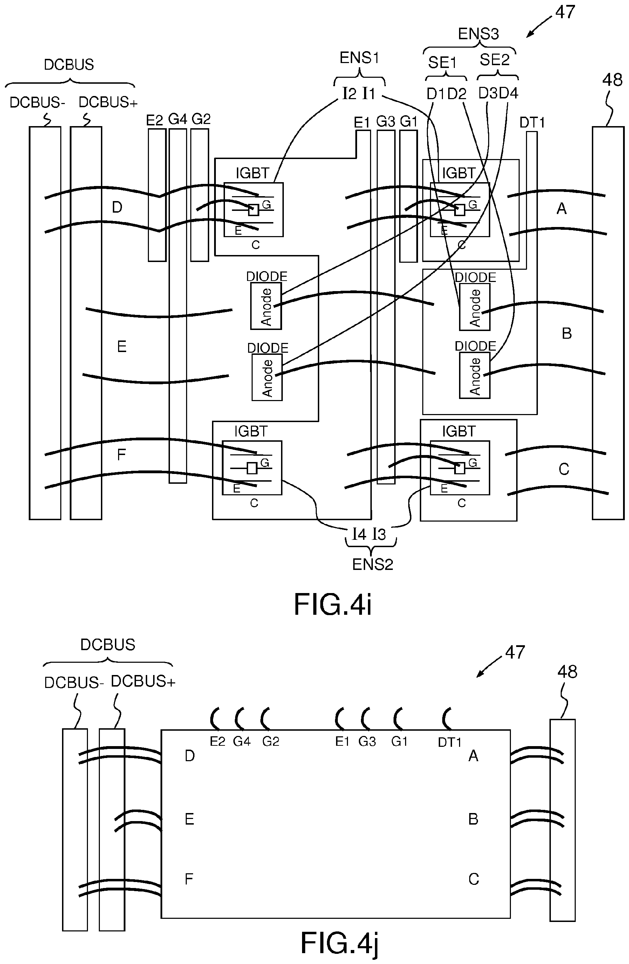

Les figures 4c, 4d, 4e, 4f, 4g, 4h, 4i et 4j illustrent alternativement de manière détaillée et schématique un demi-bras d'un convertisseur de puissance à découpage, lorsque P=2, M=2, $N_1$=2, et $N_2$=2, comme un onduleur, un hacheur, ou un gradateur, configuré pour commander au moins une phase d'un récepteur électrique polyphasé à au moins trois phases, tel un moteur électrique ou un transformateur, comprenant au moins deux bras de convertisseur, selon divers aspects de l'invention.

Ces figures illustrent un demi-bras 40 des figures 4a et 4b, connecté de diverses manières avec des interfaces de puissance et une alimentation électrique coplanaire DCBUS.

La figure 4c représente un demi-bras positif 41 d'un convertisseur de puissance à découpage, lorsque P=2, M=2, $N_1$=2, et $N_2$=2, pour une utilisation positive, i.e. dans laquelle les premier et deuxième ensembles ENS1, ENS2 sont connectés à une ligne positive d'alimentation DCBUS+, dans une implantation à gauche.

Un tel demi-bras positif 41 comprend un demi-bras 40 dont les premier et deuxième ensembles ENS1, ENS2 sont connectés à une ligne positive d'alimentation DCBUS+ d'une alimentation électrique coplanaire DCBUS, comprenant une ligne positive DCBUS+ et une ligne négative DCBUS-, disposée de manière à séparer deux bras du convertisseur, et comprenant une interface de puissance par bras, comme une barre omnibus ou barre de distribution pour "busbar" en langue anglaise.

Chaque interface de puissance est disposée de sorte que les deux demi-bras du bras correspondant soient situés entre l'alimentation électrique coplanaire DCBUS et l'interface de puissance correspondante. Les différentes connexions sont représentées par des fils de connexion 41a, et représentées par des fils de connexion bas niveau 41b.

Dans la présente implantation d'un demi-bras à gauche est représentée l'interface de puissance ou sortie de phase 42.

La figure 4d est une version est une version synthétique de la figure 4c.

La figure 4e représente un demi-bras positif 43 d'un convertisseur de puissance à découpage, lorsque P=2, M=2, $N_1$=2, et $N_2$=2, pour une utilisation positive, i.e. dans laquelle les premier et deuxième ensembles ENS1, ENS2 sont connectés à une ligne positive d'alimentation DCBUS+, dans une implantation à droite.

Un tel demi-bras positif 43 comprend un demi-bras 40 dont les premier et deuxième ensembles ENS1, ENS2 sont connectés à la ligne positive DCBUS+ d'une alimentation électrique coplanaire DCBUS, comprenant une ligne positive DCBUS+ et une ligne négative DCBUS-, disposée de manière à séparer deux bras du convertisseur, et comprenant une interface de puissance par bras, comme une barre omnibus ou barre de distribution pour "busbar" en langue anglaise.

Chaque interface de puissance est disposée de sorte que les deux demi-bras du bras correspondant soient situés entre l'alimentation électrique coplanaire DCBUS et l'interface de puissance correspondante. Les différentes connexions sont représentées par des fils de connexion 41a, et représentées par des fils de connexion bas niveau 41b.

Dans la présente implantation d'un demi-bras à droite est représentée l'interface de puissance 44.

La figure 4f est une version est une version synthétique de la figure 4e.

La figure 4g représente un demi-bras négatif 45 d'un convertisseur de puissance à découpage, lorsque P=2, M=2, $N_1$=2, et $N_2$=2, pour une utilisation négative, i.e. dans laquelle les premier et deuxième ensembles ENS1, ENS2 sont connectés à une ligne négative d'alimentation DCBUS-, dans une implantation à gauche.

Un tel demi-bras négatif 45 comprend un demi-bras 40 dont les premier et deuxième ensembles ENS1, ENS2 sont connectés à une ligne négative d'alimentation DCBUS- d'une alimentation électrique coplanaire DCBUS, comprenant une ligne positive DCBUS+ et une ligne négative DCBUS-, disposée de manière à séparer deux bras du convertisseur, et comprenant une interface de puissance par bras, comme une barre omnibus ou barre de distribution pour "busbar" en langue anglaise.

Chaque interface de puissance est disposée de sorte que les deux demi-bras du bras correspondant soient situés entre l'alimentation électrique coplanaire DCBUS et l'interface de puissance correspondante. Les différentes connexions sont représentées par des fils de connexion 41a, et représentées par des fils de connexion bas niveau 41b.

Dans la présente implantation d'un demi-bras à gauche est représentée l'interface de puissance ou sortie de phase 46.

La figure 4h est une version est une version synthétique de la figure 4g.

La figure 4i représente un demi-bras négatif 47 d'un convertisseur de puissance à découpage, lorsque P=2, M=2, $N_1$=2, et $N_2$=2, pour une utilisation négative, i.e. dans laquelle les premier et deuxième ensembles ENS1, ENS2 sont connectés à une ligne négative d'alimentation DCBUS+, dans une implantation à droite.

Un tel demi-bras négatif 47 comprend un demi-bras 40 dont les premier et deuxième ensembles ENS1, ENS2 sont connectés à la ligne négative DCBUS- d'une alimentation électrique coplanaire DCBUS, comprenant une ligne positive DCBUS+ et une ligne négative DCBUS-, disposée de manière à séparer deux bras du convertisseur, et comprenant une interface de puissance par bras, comme une barre omnibus ou barre de distribution pour "busbar" en langue anglaise.

Chaque interface de puissance est disposée de sorte que les deux demi-bras du bras correspondant soient situés entre l'alimentation électrique coplanaire DCBUS et l'interface de puissance correspondante. Les différentes connexions sont représentées par des fils de connexion 41a, et représentées par des fils de connexion bas niveau 41b.

Dans la présente implantation d'un demi-bras à droite est représentée l'interface de puissance 48.

La figure 4f est une version synthétique de la figure 4e.

Pour les figures suivantes, à des fins de représentations, seules des versions synthétiques sont utilisées.

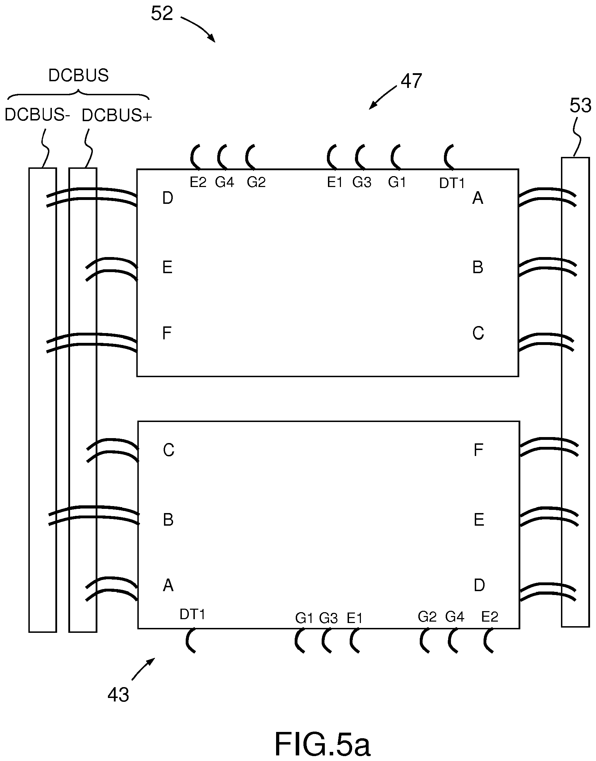

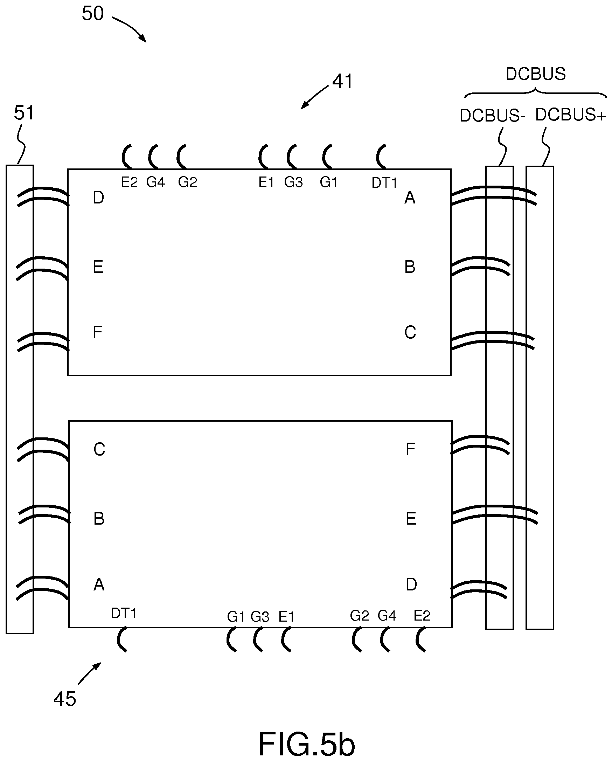

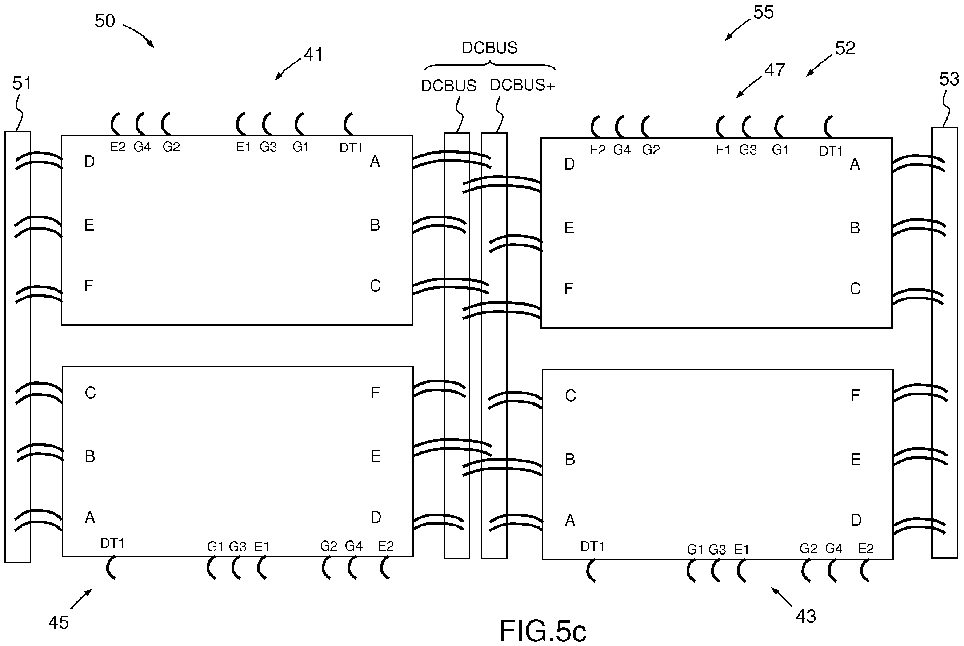

Les figures 5a et 5b représentent, de manière détaillées et synthétiques, un bras d'un convertisseur de puissance à découpage avec P=2, M=2, $N_1$=2, et $N_2$=2, et la figure 5c représente un bloc de deux bras, pouvant par exemple être utilisé comme pont en H ou comme double bras d'un convertisseur de puissance à découpage, selon un aspect de l'invention.

La figure 5b représente un bras 50 d'un convertisseur de puissance à découpage avec P=2, M=2, $N_1$=2, et $N_2$=2 à implantation à gauche, qui est composée de deux demi-bras 41, 45, l'un 41, le demi-bras positif, selon les figures 4c ou 4d et l'autre 45, le demi-bras négatif, selon la figure 4g ou 4h. L'interface de puissance DCBUS correspond aux interfaces de puissance 42 ou 46 en l'espèce identiques.

La figure 5a représente un bras 52 d'un convertisseur de puissance à découpage avec P=2, M=2, $N_1$=2, et $N_2$=2 à implantation à droite est composée de deux demi-bras 47, 43, l'un 43, le demi-bras positif, selon la figure 4d ou 4e et l'autre 47, le demi-bras négatif, selon la figure 4i ou 4j. L'interface de puissance 53 correspond aux interfaces de puissance 44 ou 48 en l'espèce identiques.

La figure 5c représente un bloc 55 de deux bras 50, 52, étant la combinaison d'un bras 50 implanté à gauche selon la figure 5b et d'un bras 52 implanté à droite selon la figure 5a, pouvant par exemple être utilisé comme pont en H ou comme double bras d'un convertisseur de puissance à découpage, selon un aspect de l'invention. Bien entendu tous ces modes de réalisation ne sont pas limitatifs, car ils peuvent être adaptés à différentes géométries.

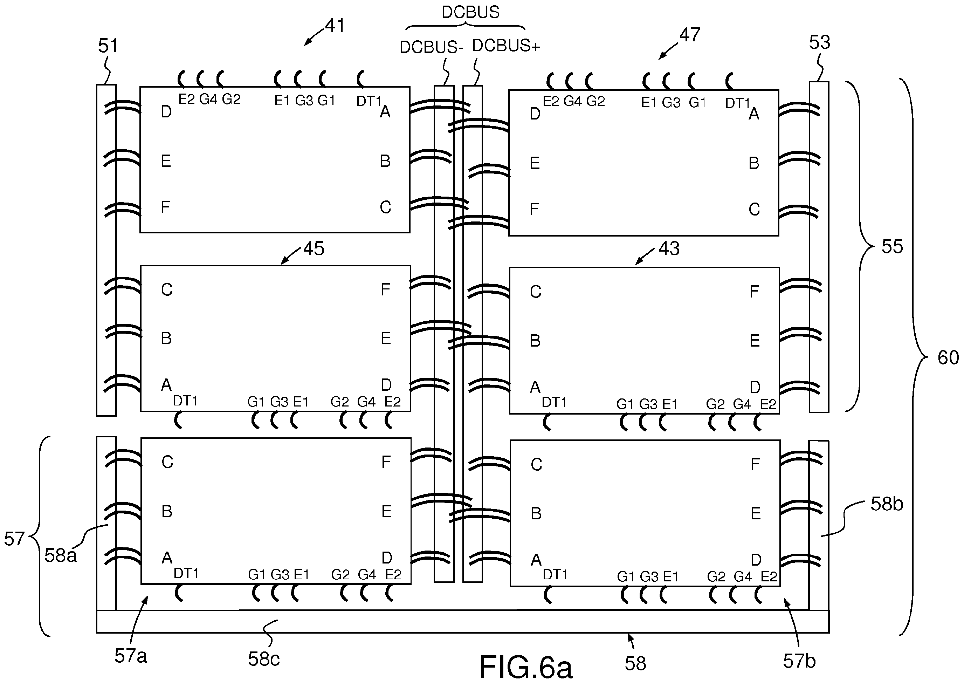

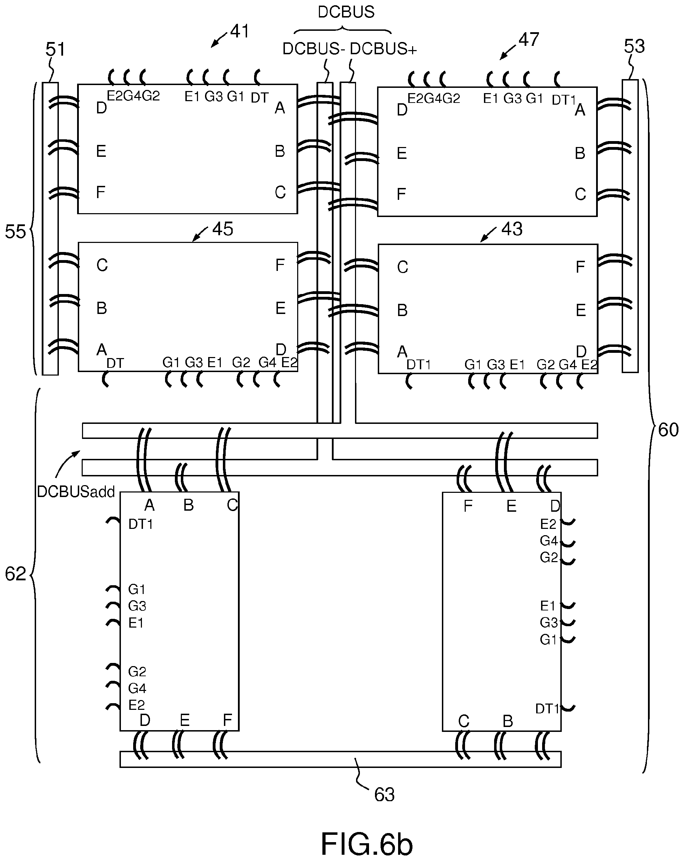

Les figures 6a et 6b représentent des exemples de réalisation d'un bloc 60 comprenant un bloc 55 de deux bras selon la figure 5c, muni d'un bras additionnel 57, 62 pour un nombre total de bras impair, selon deux modes de réalisation non limitatifs.

Le mode de réalisation de la figure 6a représente un bloc 60 comprenant un bloc 55 de deux bras, selon la figure 5c, muni d'un bras additionnel 57 comprenant deux demi-bras 57a, 57b disposés de part et d'autre de l'alimentation électrique coplanaire DCBUS prolongée. Sur le mode de réalisation, le bras additionnel 57 comprend un demi-bras négatif avec implantation à gauche 57a et un demi-bras positif avec implantation à droite 57b. Le bras additionnel 57 comprend en outre une interface de puissance 58 comprenant respectivement, pour chacun des deux demi-bras 57a, 57b, une partie 58a, 58b disposé de sorte que le demi-bras correspondant 57a, 57b est situé entre l'alimentation électrique coplanaire DCBUS et la partie de l'interface de puissance correspondante, ou, en d'autre termes la prolongation de l'interface de puissance 58a, 58b. En l'espèce, l'interface de puissance 58 du bras additionnel 57, comprend donc trois parties 58a, 58b et 58c formant un U.

Le mode de réalisation de la figure 6b représente un bloc 60 comprenant un bloc 55 de deux bras, selon la figure 5c, muni d'un bras additionnel 62. Le bloc 60 comprend en outre, une portion additionnelle DCBUSadd d'alimentation électrique coplanaire disposée à une extrémité et dans une direction différente du reste de l'alimentation électrique coplanaire DCBUS, et une interface de puissance 63 du bras additionnel 62 disposée de sorte que le bras additionnel 62 est situé entre ladite portion additionnelle DCBUSadd d'alimentation électrique coplanaire et ladite interface de puissance correspondante 63.

La portion additionnelle DCBUSadd d'alimentation électrique coplanaire peut avantageusement être sensiblement perpendiculaire au reste de l'alimentation électrique coplanaire DCBUS.

En l'espèce, l'alimentation électrique coplanaire DCBUS, DCBUSadd forme un T à l'envers.

En cours de commutation, lors des phases dites de "roue libre", les courants s'échangent entre les bras d'onduleur du pont en H à travers les lignes d'alimentation DCBUS+, DCBUS-. Suivant l'inductance parasite de ces lignes, des surtensions vont y être générées.

La présente invention propose de placer les bras d'onduleur dos à dos, de manière à ce que les échanges de courants entre les deux bras d'onduleur soient les plus directs possible, donc les moins inductifs possibles.

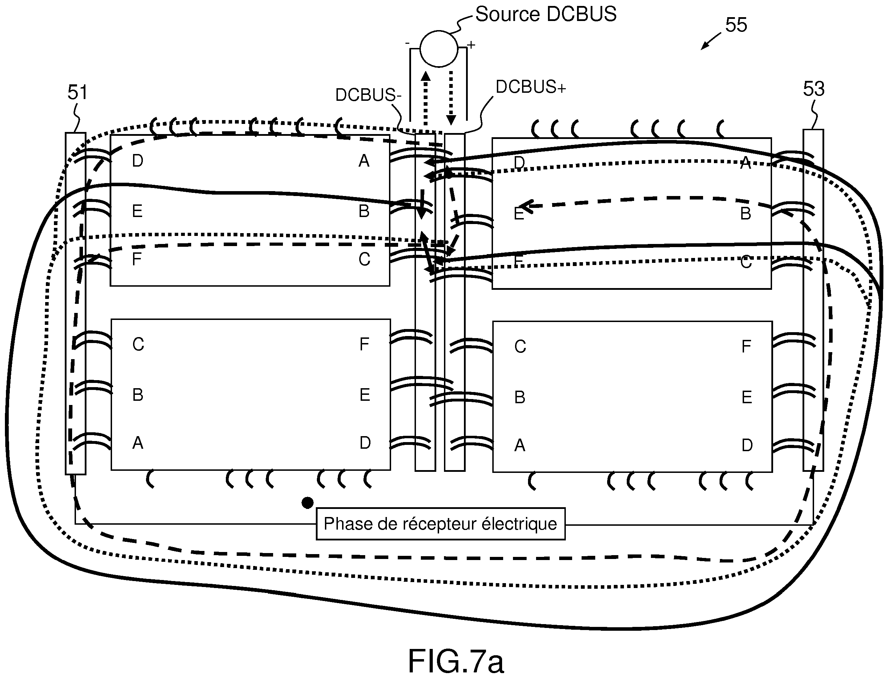

La figure 7a illustre les circulations des courants électriques dans un bloc 55 de deux bras utilisé comme pont en H pour une phase de récepteur électrique Phase, dans le cas d'un courant électrique de phase positif.

Pour la "roue libre" dans la barre d'alimentation positive DCBUS+, le courant suit le chemin indiqué par les flèches en traits de tirets.

Pour la "roue libre" dans la barre d'alimentation négative DCBUS-, le courant suit le chemin indiqué par les flèches en traits pleins ou continus.

Les flèches en traits de pointillés indiquent la circulation du courant, pendant la période active. Pendant cette période, le courant est issu de la source DCBUS sous la tension $V_{DCBUS}$, ce qui correspond à l'énergie délivrée par la source à la phase.

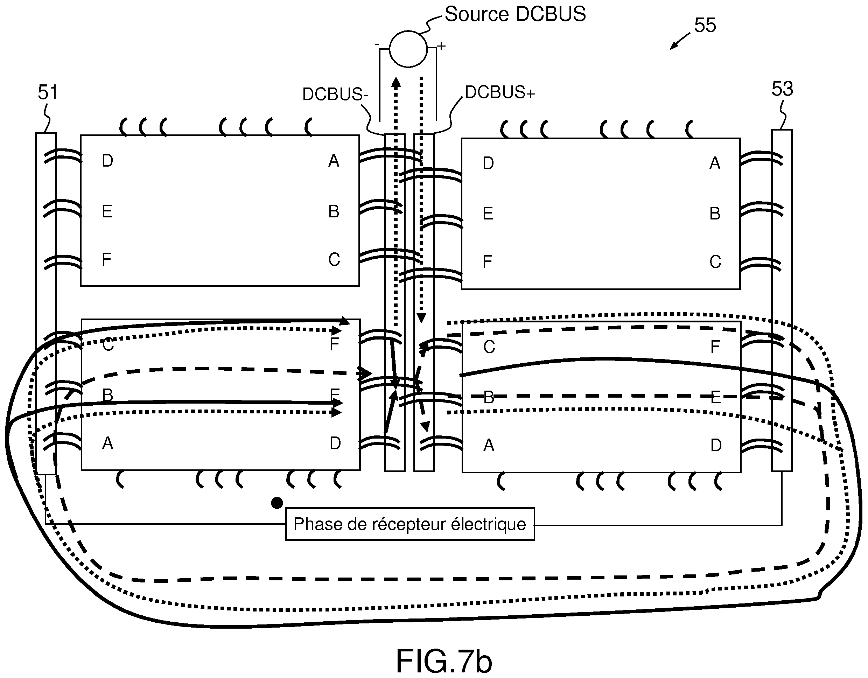

La figure 7b illustre les circulations des courants électriques dans un bloc 55 de deux bras utilisé comme pont en H pour une phase de récepteur électrique Phase, dans le cas d'un courant électrique de phase négatif.

Pour la "roue libre" dans la barre d'alimentation positive, le courant suit le chemin indiqué par les flèches en traits pointillés.

Pour la "roue libre" dans la barre d'alimentation négative, le courant suit le chemin indiqué par les flèches en traits pleins ou continus.

Les flèches en traits pointillés indiquent la circulation du courant, pendant la période active. Pendant cette période, le courant est issu de la source DCBUS sous la tension $V_{DCBUS}$, ce qui correspond à l'énergie délivrée par la source à la phase.

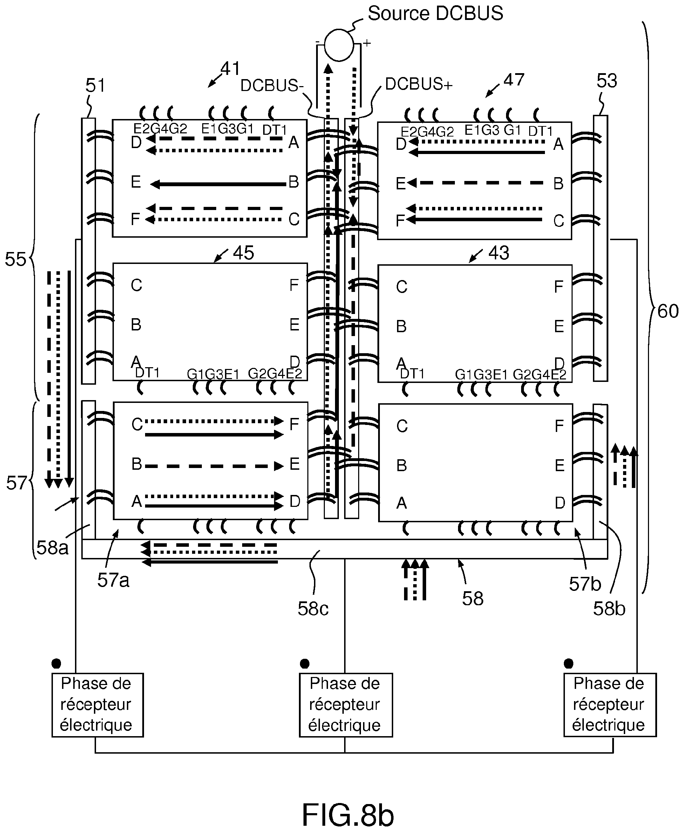

La figure 8b illustre le cas d'un nombre impair (2M+1) de phases du récepteur électrique, en l'occurrence trois phases Phase1, Phase2, Phase3 et un neutre du récepteur électrique.

Le récepteur électrique, par exemple le moteur électrique tournant sur 360°, chaque phase (prenons le cas du triphasé) est déphasée de 120° mais chaque phase voit un courant de type I= Io cos $(\omega t + \theta)$ où $\theta$ vaut respectivement 0, 120° et 240°.

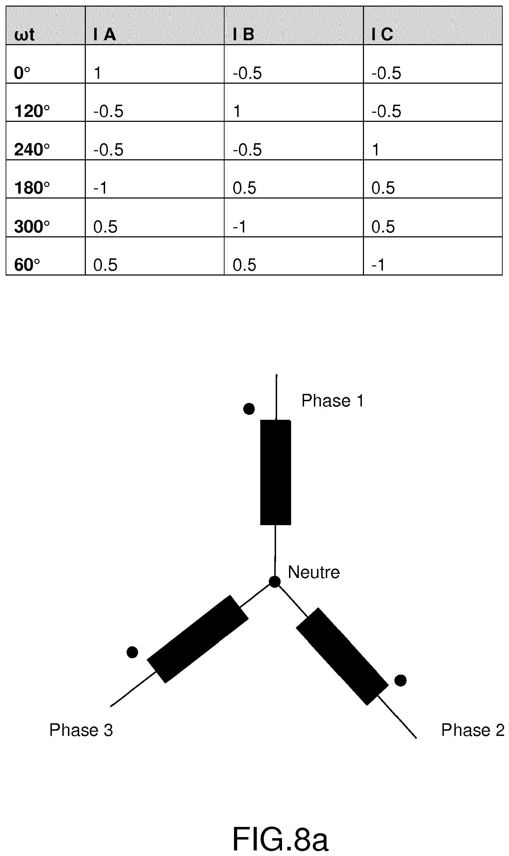

On peut trouver des angles remarquables (tous les 60°) respectant le tableau de la figure 8a, il est donc possible d'étudier plus aisément la circulation des courants commutés pour les angles remarquables.

D'autre part, le raccordement est d'office avec un neutre Neutre comme représenté sur le dessin de la figure 8b.

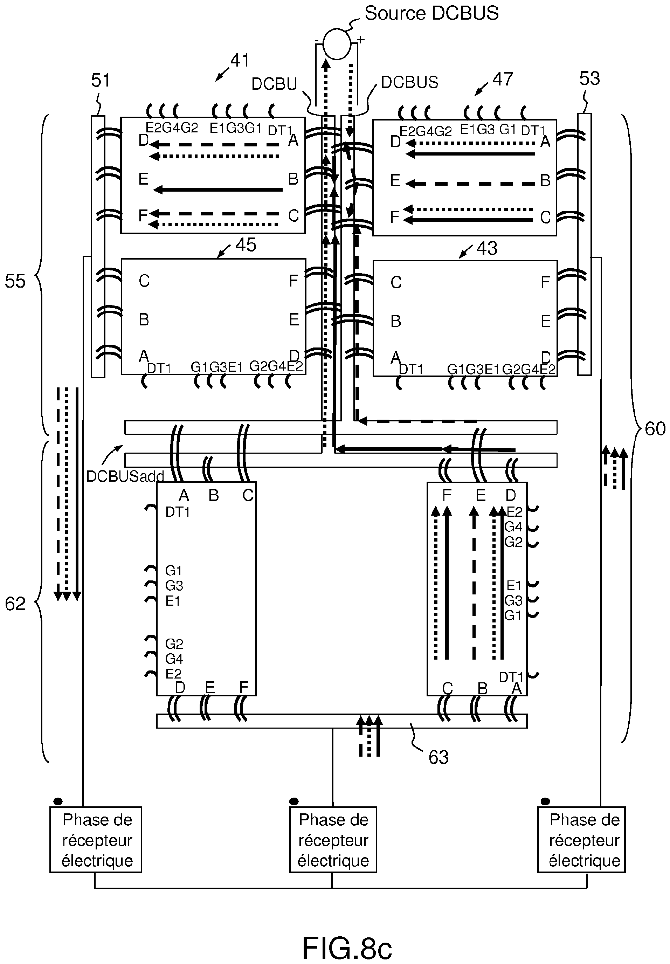

Les figures 8b et 8c illustrent les circulations des courants électriques dans un bloc des figures 6a et 6b avec un récepteur électrique à trois phases et neutre, dans le cas de l'angle remarquable 0° où les trois courants ont les proportions respectives : 1, -0.5, -0.5.

Au vu des deux figures 8b et 8c de circulation de courant, les courants électriques de commutation de la phase impaire reviennent à travers le busbar DCBUS (DCBUS+ et DCBUS-) ; si le busbar coplanaire est de bonne qualité, la self ou inductance est très faible puisque la différence de chemin entre les tracés en traits pleins ou continus, en traits pointillés et en traits de tirets est minime.

Le choix entre un dessin T à l'envers de la figure 8c et un dessin en U de la figure 8b sera dicté par l'implantation dont l'inductance parasite du segment de DCBUS nécessaire pour alimenter les deux demi-bras de la phase impaire sera la plus faible.

Aussi, la présente invention répond à l'exigence de tolérance aux pannes, y compris celles des circuits de commande.

En réduisant à leurs minima les inductances parasites, la solution permet d'utiliser des composants mieux dimensionnés en tension électrique, ce qui entraîne moins de pertes Joules dans le convertisseur de puissance, donc un meilleur rendement et un dimensionnement thermique optimal.

En réduisant à leurs minima les inductances parasites, la présente invention permet de mieux exploiter la tension d'alimentation.

En favorisant la compacité de la solution, l'invention en réduit la masse, critère important dans le monde des lanceurs et des satellites.

## Revendications

1. Convertisseur de puissance à découpage configuré pour commander au moins une phase d'un récepteur électrique polyphasé à au moins trois phases, comprenant au moins un bloc de deux bras de convertisseur, dans lequel un demi-bras (40, 41, 43, 45, 47) de chaque bras de convertisseur comprend :

   - un premier ensemble (ENS1) de P≥2 interrupteurs (I1, I2) en série;
   - un deuxième ensemble (ENS2) de P≥2 interrupteurs (I3, I4) en série;
   - ledit premier ensemble (ENS1) et ledit deuxième ensemble (ENS2) étant électriquement connecté entre une ligne d'alimentation (DCBUS+, DCBUS-) d'une alimentation électrique coplanaire (DCBUS) et une interface de puissance (51, 53); et
   - un troisième ensemble (ENS3) de diodes (D1, D2, D3, D4), disposé spatialement entre le premier ensemble (ENS1) et le deuxième ensemble (ENS2), comprenant M≥2 sous-ensembles (SE1, SE2, ...,SEM) en série, indicés $i \in [\![1; M]\!]$, comprenant respectivement $N_i$≥2 diodes en parallèle, ledit troisième ensemble (ENS3) étant électriquement connecté entre l'interface de puissance (51, 53) et l'autre ligne d'alimentation (DCBUS-, DCBUS+) de l'alimentation électrique coplanaire

   (DCBUS), lesdits premier, deuxième et troisième ensembles étant disposés pour permettre une tolérance à la simple panne en court-circuit ou en circuit ouvert des éléments du demi-bras (40, 41, 43, 45, 47).

2. Convertisseur de puissance à découpage selon la revendication 1, dans lequel les M sous-ensembles (SE1, SE2) comprennent un même nombre $N_i$ de diodes en parallèle.

**3.** Convertisseur de puissance à découpage selon l'une des revendications précédentes, comprenant au moins un capteur de température.

**4.** Convertisseur de puissance à découpage selon la revendication 1, dans lequel les interrupteurs du premier ensemble (ENS1) sont alignés et/ou les interrupteurs du deuxième ensemble (ENS2) sont alignés et/ou les sous-ensembles (SE1, SE2) de diodes du troisième ensemble (ENS3) sont alignés.

**5.** Convertisseur de puissance à découpage selon l'une des revendications précédentes, dans lequel un bloc (55) de deux bras comprend une alimentation électrique coplanaire (DCBUS), munie d'une ligne positive (DCBUS+) et d'une ligne négative (DCBUS-), disposée de manière à séparer deux bras (50, 52) du convertisseur, et comprenant une interface de puissance (51, 53) par bras, chaque interface de puissance étant disposée de sorte que les deux demi-bras ((41, 45), (43, 47)) du bras correspondant sont situés entre l'alimentation électrique coplanaire (DCBUS) et l'interface de puissance correspondante (51, 53).

**6.** Convertisseur de puissance à découpage selon la revendication 5, dans lequel deux demi-bras formant un bras (50, 52) d'un bloc (55) de deux bras du convertisseur, comprennent

- un demi-bras positif (41, 43) comprenant un troisième ensemble (ENS3) connecté entre la ligne négative (DCBUS-) de l'alimentation électrique coplanaire (DCBUS) et l'interface de puissance correspondante (51, 53), et un premier ensemble (ENS1) et un deuxième ensemble (ENS2) connectés entre la ligne positive (DCBUS+) de l'alimentation électrique coplanaire (DCBUS) et l'interface de puissance correspondante (51, 53), et
- un demi-bras négatif (45, 47) comprenant un troisième ensemble (ENS3) connecté entre la ligne positive (DCBUS+) de l'alimentation électrique coplanaire (DCBUS) et l'interface de puissance correspondante (51, 53), et un premier ensemble (ENS1) et un deuxième ensemble (ENS2) connectés entre la ligne négative (DCBUS-) de l'alimentation électrique coplanaire (DCBUS) et l'interface de puissance correspondante (51, 53).

**7.** Convertisseur de puissance à découpage selon la revendication 6, dans lequel un demi-bras négatif (45,47) d'un bras (50, 52) d'un bloc (55) de deux bras du convertisseur est disposé en vis-à-vis d'un demi-bras positif (41, 43) de l'autre bras du bloc de deux bras du convertisseur, par rapport à l'alimentation électrique coplanaire (DCBUS).

**8.** Convertisseur de puissance à découpage selon l'une des revendications précédentes, dans lequel, lorsque le nombre de bras est impair, le convertisseur comprend desdits blocs (55) de deux bras, et un bloc (55) de deux bras muni d'un bras additionnel (57, 62).

**9.** Convertisseur de puissance à découpage selon la revendication 8, dans lequel ledit bloc (55) de deux bras est muni d'un bras additionnel (57) comprenant deux demi-bras (57a, 57b) disposés de part et d'autre de l'alimentation électrique coplanaire (DCBUS) prolongée, et une interface de puissance (58) dudit bras additionnel (57) comprenant respectivement, pour chacun des deux demi-bras (57a, 57b), une partie (58a, 58b) disposée de sorte que le demi-bras correspondant (57a, 57b) est situé entre l'alimentation électrique coplanaire (DCBUS) et ladite partie (58a, 58b) de l'interface de puissance correspondante (58).

**10.** Convertisseur de puissance à découpage selon la revendication 8, dans lequel ledit bloc (55) de deux bras muni d'un bras additionnel (62) comprend en outre, une portion additionnelle (DCBUSadd) d'alimentation électrique coplanaire (DCBUS) disposée à une extrémité et dans une direction différente du reste de l'alimentation électrique coplanaire, et une interface de puissance (63) dudit bras additionnel (62) disposée de sorte que ledit bras additionnel (62) est situé entre ladite portion additionnelle (DCBUSadd) d'alimentation électrique coplanaire et ladite interface de puissance (63) correspondante.

**11.** Convertisseur de puissance à découpage selon la revendication 10, dans lequel ladite portion additionnelle (DCBUSadd) d'alimentation électrique coplanaire (DCBUS) est sensiblement perpendiculaire au reste de l'alimentation électrique coplanaire.

**12.** Convertisseur de puissance à découpage selon l'une des revendications précédentes, **caractérisé en ce qu'**il est hybride.

**13.** Convertisseur de puissance à découpage selon l'une des revendications précédentes, dans lequel les interrupteurs (I1, I2, I3, I4) comprennent au moins un transistor bipolaire à grille isolée et/ou au moins un transistor à effet de champ à grille isolée.

**14.** Convertisseur de puissance à découpage selon l'une des revendications précédentes, ledit convertisseur étant un onduleur ou un hacheur.

**15.** Système de commande d'au moins un vérin électrique d'un lanceur spatial comprenant au moins un convertisseur de puissance à découpage selon l'une des revendications précédentes, le récepteur électrique étant un moteur électrique et le convertisseur de puissance étant un onduleur.

16. Lanceur spatial muni d'un système selon la revendication 15.

17. Système de commande d'au moins un dispositif d'orientation d'antennes ou de panneaux solaires d'un satellite comprenant au moins un convertisseur de puissance à découpage selon l'une des revendications 1 à 15, le récepteur électrique étant un moteur électrique et le convertisseur de puissance étant un onduleur.

18. Satellite muni d'un système de commande selon la revendication 17.

19. Système d'alimentation d'un satellite comprenant au moins un convertisseur de puissance à découpage selon l'une des revendications 1 à 14, le récepteur électrique étant un transformateur polyphasé et le convertisseur de puissance étant un onduleur ou hacheur.

20. Satellite muni d'un système d'alimentation selon la revendication 19.

**Patentansprüche**

1. Schalt-Leistungswandler, konfiguriert zur Steuerung mindestens einer Phase eines mehrphasigen elektrischen Empfängers mit mindestens drei Phasen, umfassend mindestens einen Block mit zwei Wandlerarmen, wobei ein Halbarm (40, 41, 43, 45, 47) eines jeden Wandlerarms Folgendes umfasst:

- eine erste Gruppe (ENS1) von $P \geq 2$ Schaltern (I1, I2) in Reihe;
- eine zweite Gruppe (ENS2) von $P \geq 2$ Schaltern (I3, I4) in Reihe;
- wobei die erste Gruppe (ENS1) und die zweite Gruppe (ENS2) elektrisch zwischen einer Speiseleitung (DCBUS+, DCBUS-) einer koplanaren elektrischen Speisung (DCBUS) und einer Leistungsschnittstelle (51, 53) verbunden sind; und
- eine dritte Gruppe (ENS3) von Dioden (D1, D2, D3, D4), welche räumlich zwischen der ersten Gruppe (ENS1) und der zweiten Gruppe (ENS2) angeordnet ist, umfassend $M \geq 2$ Teilgruppen (SE1, SE2, ...,SEM) in Reihe, indiziert $i \in [[1 ; M]]$, jeweils umfassend $N_i \geq 2$ parallelgeschaltete Dioden, wobei die dritte Gruppe (ENS3) elektrisch zwischen der Leistungsschnittstelle (51, 53) und der anderen Speiseleitung (DCBUS-, DCBUS+) der koplanaren elektrischen Speisung (DCBUS) verbunden ist, wobei die erste, die zweite und die dritte Gruppe angeordnet sind, um eine Toleranz gegenüber einem einfachen Ausfall bei Kurzschluss oder unterbrochenem Schaltkreis der Elemente des Halbarms (40, 41, 43, 45, 47) zu ermöglichen.

2. Schalt-Leistungswandler nach Anspruch 1, wobei die M Teilgruppen (SE1, SE2) eine gleiche Anzahl an $N_i$ parallelgeschalteten Dioden aufweisen.

3. Schalt-Leistungswandler nach einem der vorhergehenden Ansprüche, umfassend mindestens einen Temperatursensor.

4. Schalt-Leistungswandler nach Anspruch 1, wobei die Schalter der ersten Gruppe (ENS1) ausgefluchtet sind und/oder die Schalter der zweiten Gruppe (ENS2) ausgefluchtet sind und/oder die Teilgruppen (SE1, SE2) von Dioden der dritten Gruppe (ENS3) ausgefluchtet sind.

5. Schalt-Leistungswandler nach einem der vorhergehenden Ansprüche, wobei ein zweiarmiger Block (55) eine koplanare elektrische Speisung (DCBUS) umfasst, versehen mit einer positiven Leitung (DCBUS+) und einer negativen Leitung (DCBUS-), welche dergestalt angeordnet ist, dass sie die beiden Arme (50, 52) des Wandlers trennt, und umfassend eine Leistungsschnittstelle (51, 53) pro Arm, wobei jede Leistungsschnittstelle so angeordnet ist, dass die beiden Halbarme ((41, 45), (43, 47)) des entsprechenden Arms zwischen der koplanaren elektrischen Speisung (DCBUS) und der entsprechenden Leistungsschnittstelle (51, 53) angeordnet sind.

6. Schalt-Leistungswandler nach Anspruch 5, wobei zwei Halbarme, welche einen Arm (50, 52) eines zweiarmigen Blocks (55) des Wandlers bilden, Folgendes umfassen:

- einen positiven Halbarm (41, 43), umfassend eine dritte Gruppe (ENS3), welche zwischen der negativen Leitung (DCBUS-) der koplanaren elektrischen Speisung (DCBUS) und der entsprechenden Leistungsschnittstelle (51, 53) verbunden ist, und eine erste Gruppe (ENS1) und eine zweite Gruppe (ENS2), welche zwischen der positiven Leitung (DCBUS+) der koplanaren elektrischen Speisung (DCBUS) und der entsprechenden Leistungsschnittstelle (51, 53) verbunden sind, und
- einen negativen Halbarm (45, 47), umfassend eine dritte Gruppe (ENS3), welche zwischen der positiven Leitung (DCBUS+) der koplanaren elektrischen Speisung (DCBUS) und der entsprechenden Leistungsschnittstelle (51, 53) verbunden ist, und eine erste Gruppe (ENS1) und eine zweite Gruppe (ENS2), welche zwischen der negativen Leitung (DCBUS-) der koplanaren elektrischen Speisung (DCBUS) und der entsprechenden Leistungsschnittstelle (51, 53) verbunden sind.

7. Schalt-Leistungswandler nach Anspruch 6, wobei ein negativer Halbarm (45,47) eines Arms (50, 52) eines zweiarmigen Blocks (55) des Wandlers gegenüber einem positiven Halbarm (41, 43) des anderen Arms des zweiarmigen Blocks des Wandlers in Bezug auf die koplanare elektrische Speisung (DCBUS) angeordnet ist.

8. Schalt-Leistungswandler nach einem der vorhergehenden Ansprüche, wobei, wenn die Anzahl der Arme ungerade ist, der Wandler zweiarmige Blöcke (55) und einen zweiarmigen Block (55) umfasst, welcher mit einem zusätzlichen Arm (57, 62) versehen ist.

9. Schalt-Leistungswandler nach Anspruch 8, wobei der zweiarmige Block (55) mit einem zusätzlichen Arm (57) versehen ist, umfassend zwei Halbarme (57a, 57b), welche beiderseits der verlängerten koplanaren elektrischen Speisung (DCBUS) angeordnet sind, und eine Leistungsschnittstelle (58) des zusätzlichen Arms (57), welche jeweils für jeden der Halbarme (57a, 57b), einen Teil (58a, 58b) umfasst, welcher so angeordnet ist, dass der entsprechende Halbarm (57a, 57b) zwischen der koplanaren elektrischen Speisung (DCBUS) und dem Teil (58a, 58b) der entsprechenden Leistungsschnittstelle (58) angeordnet ist.

10. Schalt-Leistungswandler nach Anspruch 8, wobei der zweiarmige Block (55), welcher mit einem zusätzlichen Arm (62) versehen ist, ferner einen zusätzlichen Abschnitt (DCBUSadd) der koplanaren elektrischen Speisung (DCBUS) umfasst, welcher an einem Ende und in einer vom Rest der koplanaren elektrischen Speisung unterschiedlichen Richtung angeordnet ist, und eine Leitungsschnittstelle (63) des zusätzlichen Arms (62) so angeordnet ist, dass der zusätzliche Arm (62) zwischen dem zusätzlichen Abschnitt (DCBUSadd) der koplanaren elektrischen Speisung und der entsprechenden Leistungsschnittstelle (63) angeordnet ist.

11. Schalt-Leistungswandler nach Anspruch 10, wobei der zusätzliche Abschnitt (DCBUSadd) der koplanaren elektrischen Speisung (DCBUS) im Wesentlichen rechtwinklig zum Rest der koplanaren elektrischen Speisung ist.

12. Schalt-Leistungswandler nach einem der vorhergehenden Ansprüche, **dadurch gekennzeichnet, dass** er hybrid ist.

13. Schalt-Leistungswandler nach einem der vorhergehenden Ansprüche, wobei die Schalter (I1, I2, I3, I4) mindestens einen Bipolartransistor mit isoliertem Gatter und/oder mindestens einen Feldeffekttransistor mit isoliertem Gatter umfassen.

14. Schalt-Leistungswandler nach einem der vorhergehenden Ansprüche, wobei der Wandler ein Wechselrichter oder ein Zerhacker ist.

15. Steuerungssystem für mindestens einen elektrischen Druckzylinder einer Trägerrakete, umfassend mindestens einen Schalt-Leistungswandler nach einem der vorhergehenden Ansprüche, wobei der elektrische Empfänger ein Elektromotor ist und der Leistungswandler ein Wechselrichter ist.

16. Trägerrakete, welche mit einem System nach Anspruch 15 versehen ist.

17. Steuerungssystem für mindestens eine Antennenoder Solarplatten-Ausrichtungsvorrichtung eines Satelliten, umfassend mindestens einen Schalt-Leistungswandler nach einem der Ansprüche 1 bis 15, wobei der elektrische Empfänger ein Elektromotor ist und der Leistungswandler ein Wechselrichter ist.

18. Satellit, welcher mit einem Steuerungssystem nach Anspruch 17 versehen ist.

19. Speisungssystem für einen Satelliten, umfassend mindestens einen Schalt-Leistungswandler nach einem der Ansprüche 1 bis 14, wobei der elektrische Empfänger ein mehrphasiger Transformator ist und der Leistungswandler ein Wechselrichter oder ein Gleichstromsteller ist.

20. Satellit, welcher mit einem Speisungssystem nach Anspruch 19 versehen ist.

**Claims**

1. Switched-mode power converter configured to control at least one phase of a polyphase electrical receiver with at least three phases, comprising at least one block of two converter arms, wherein a half-arm (40, 41, 43, 45, 47) of each converter arm comprises:

    - a first set (ENS1) of P≥2 switches (I1, I2) in series;
    - a second set (ENS2) of P≥2 switches (I3, I4) in series,
    - said first set (ENS1) and second set (ENS2) being electrically connected between a power supply line (DCBUS+, DCBUS-) of a coplanar electrical power supply (DCBUS) and a power interface (51, 53); and

- a third set (ENS3) of diodes (D1, D2, D3, D4), spatially arranged between the first set (ENS1) and the second set (ENS2), comprising M≥2 subsets (SE1, SE2, ...,SEM) in series, indexed

$$i \in [\![1; M]\!]$$

, respectively comprising $N_i \geq 2$ diodes in parallel, said third set (ENS3) being electrically connected between the power interface (51, 53) and the other power supply line (DCBUS-, DCBUS+) of the coplanar electrical power supply (DCBUS), said first, second and third sets being arranged to allow tolerance for the simple short-circuit or open-circuit failure of half-arm components (40, 41, 43, 45, 47).

2. Switched-mode power converter according to claim 1, wherein the M subsets (SE1, SE2) comprise a same number $N_i$ of diodes in parallel.

3. Switched-mode power converter according to one of the preceding claims, comprising at least one temperature sensor.

4. Switched-mode power converter according to claim 1, wherein the switches of the first set (ENS1) are aligned and/or the switches of the second set (ENS2) are aligned and/or the subsets (SE1, SE2) of diodes of the third set (ENS3) are aligned.

5. Switched-mode power converter according to one of the preceding claims, wherein a block (55) of two arms comprises a coplanar electrical power supply (DCBUS), provided with a positive line (DCBUS+) and a negative line (DCBUS-), arranged so as to separate two arms (50, 52) of the converter, and comprising a power interface (51, 53) for each arm, each power interface being arranged such that the two half-arms ((41, 45), (43, 47)) of the corresponding arm are situated between the coplanar electrical power supply (DCBUS) and the corresponding power interface (51, 53).

6. Switched-mode power converter according to claim 5, wherein two half-arms forming an arm (50, 52) of a block (55) of two arms of the converter, comprise

- a positive half-arm (41, 43) comprising a third set (ENS3) connected between the negative line (DCBUS-) of the coplanar electrical power supply (DCBUS) and the corresponding power interface (51, 53), and a first set (ENS1) and a second set (ENS2) connected between the positive line (DCBUS+) of the coplanar electrical power supply (DCBUS) and the corresponding power interface (51, 53), and
- a negative half-arm (45, 47) comprising a third set (ENS3) connected between the positive line (DCBUS+) of the coplanar electrical power supply (DCBUS) and the corresponding power interface (51, 53), and a first set (ENS1) and a second set (ENS2) connected between the negative line (DCBUS-) of the coplanar electrical power supply (DCBUS) and the corresponding power interface (51, 53).

7. Switched-mode power converter according to claim 6, wherein a negative half-arm (45, 47) of an arm (50, 52) of a block (55) of two arms of the converter is arranged facing a positive half-arm (41, 43) of the other arm of the block of two arms of the converter, relative to the coplanar electrical power supply (DCBUS).

8. Switched-mode power converter according to one of the preceding claims, wherein, when the number of arms is odd, the converter comprises said blocks (55) of two arms, and a block (55) of two arms provided with an additional arm (57, 62).

9. Switched-mode power converter according to claim 8, wherein said block (55) of two arms is provided with an additional arm (57) comprising two half-arms (57a, 57b) arranged on either side of the extended coplanar electrical power supply (DCBUS), and a power interface (58) of said additional arm (57) comprising respectively, for each of the two half-arms (57a, 57b), a part (58a, 58b) arranged such that the corresponding half-arm (57a, 57b) is situated between the coplanar electrical power supply (DCBUS) and said part (58a, 58b) of the corresponding power interface (58).

10. Switched-mode power converter according to claim 8, wherein said block (55) of two arms provided with an additional arm (62) further comprises an additional portion (DCBUSadd) of the coplanar electrical power supply (DCBUS) arranged at one end and in a different direction from the rest of the coplanar electrical power supply, and a power interface (63) of said additional arm (62) arranged such that said additional arm (62) is situated between said additional portion (DCBUSadd) of the coplanar electrical power supply and said corresponding power interface (63).

11. Switched-mode power converter according to claim 10, wherein said additional portion (DCBUSadd) of the coplanar electrical power supply (DCBUS) is substantially at right angles to the rest of the coplanar electrical power supply.

12. Switched-mode power converter according to one of the preceding claims, **characterized in that** it is hybrid.

13. Switched-mode power converter according to one of the preceding claims, wherein the switches (I1, I2, I3, I4) comprise at least one insulated gate bipolar transistor and/or at least one insulated gate field effect transistor.

14. Switched-mode power converter according to one of the preceding claims, said converter being an inverter or a chopper.

15. System for controlling at least one electrical cylinder actuator of a space launch vehicle comprising at least one switched-mode power converter according to one of the preceding claims, the electrical receiver being an electric motor and the power converter being an inverter.

16. Space launch vehicle provided with a system according to claim 15.

17. System for controlling at least one steering device for antennas or solar panels of a satellite comprising at least one switched-mode power converter according to one of claims 1 to 15, the electrical receiver being an electric motor and the power converter being an inverter.

18. Satellite provided with a control system according to claim 17.

19. Power supply system of a satellite comprising at least one switched-mode power converter according to one of claims 1 to 14, the electrical receiver being a polyphase transformer and the power converter being an inverter or chopper.

20. Satellite provided with a power supply system according to claim 19.

FIG.1a

FIG.1b

**FIG.2a**

**FIG.2b**

FIG.3a

FIG.3b

FIG.4a

FIG.4b

FIG.4c

FIG.4d

FIG.4e

FIG.4f

FIG.4g

FIG.4h

FIG.4i

FIG.4j

52

DCBUS

DCBUS-  DCBUS+

47

53

| | E2 G4 G2 | E1 G3 G1 | DT1 | |
|---|---|---|---|---|
| D | | | | A |
| E | | | | B |
| F | | | | C |

| | | | | |
|---|---|---|---|---|
| C | | | | F |
| B | | | | E |
| A | DT1 | G1 G3 E1 | G2 G4 E2 | D |

43

FIG.5a

50

41

DCBUS

DCBUS- DCBUS+

51

E2 G4 G2   E1 G3 G1   DT1

| D |   | A |
| E |   | B |
| F |   | C |

| C |   | F |
| B |   | E |
| A |   | D |

DT1   G1 G3 E1   G2 G4 E2

45

FIG.5b

FIG.5c

FIG.6a

EP 3 379 710 B1

FIG.6b

FIG.7a

FIG.7b

| ωt | I A | I B | I C |
|---|---|---|---|
| 0° | 1 | -0.5 | -0.5 |
| 120° | -0.5 | 1 | -0.5 |
| 240° | -0.5 | -0.5 | 1 |
| 180° | -1 | 0.5 | 0.5 |
| 300° | 0.5 | -1 | 0.5 |
| 60° | 0.5 | 0.5 | -1 |

Phase 1

Neutre

Phase 3

Phase 2

FIG.8a

Source DCBUS

FIG.8b

FIG.8c

**RÉFÉRENCES CITÉES DANS LA DESCRIPTION**

**Documents brevets cités dans la description**

- DE 102004037078 A1
- US 6600238 B1
- US 5731970 A